# EUROPEAN PATENT APPLICATION

(11) **EP 4 598 303 A1**
(43) Date of publication of application: **06.08.2025**
(21) Application number: 24204371.9
(22) Date of filing: 02.10.2024
(51) Int. Cl.: H10D 84/01, H10D 30/01, H10D 30/00, H10D 64/01, H10D 84/03, H10D 84/83, H10D 84/85

(54) **SEMICONDUCTOR DEVICE**

(30) Priority: 05.02.2024 KR 20240017544
(71) Applicant: Samsung Electronics Co., Ltd, Suwon-si, Gyeonggi-do 16677 (KR)
(72) Inventor: KIM, Bumcheol, 16677 Suwon-si (KR); KIM, Younggwon, 16677 Suwon-si (KR); KIM, Jong Pil, 16677 Suwon-si (KR); MORIYAMA, Yoshiya, 16677 Suwon-si (KR); HONG, Byoung Hak, 16677 Suwon-si (KR); LEE, Sunyoung, 16677 Suwon-si (KR); KWON, Wookhyun, 16677 Suwon-si (KR); KIM, Dongwon, 16677 Suwon-si (KR)
(74) Representative: Marks & Clerk LLP

(57) **Abstract**

Disclosed is a semiconductor device comprising a substrate including first and second active patterns, first and second channel patterns on the first and second active patterns and each including first and second semiconductor patterns, first source/drain patterns connected to the first channel pattern, second source/drain patterns connected to the second channel pattern, a first inner gate electrode between neighboring first semiconductor patterns, a second inner gate electrode between neighboring second semiconductor patterns, a first inner gate spacer between the first inner gate electrode and the first source/drain pattern, and a second inner gate spacer between the second inner gate electrode and the second source/drain pattern. The first inner gate spacer has a first thickness. The second inner gate spacer has a second thickness. The first thickness is greater than the second thickness.

## Description

### FIELD

The present inventive concepts relate to a semiconductor device and a method of fabricating the same, and more particularly, to a semiconductor device including a field effect transistor and a method of fabricating the same.

### BACKGROUND

A semiconductor device includes an integrated circuit including metal oxide semiconductor field effect transistors (MOSFETs). As sizes and design rules of the semiconductor device are gradually decreased, sizes of the MOSFETs are also increasingly scaled down. The scale down of MOSFETs may deteriorate operating characteristics of the semiconductor device. Accordingly, various studies have been conducted to develop methods of fabricating semiconductor devices having superior performances while overcoming limitations caused by high integration of the semiconductor devices.

### SUMMARY

Some embodiments of the present inventive concepts provide a semiconductor device having improved electrical characteristics and/or increased reliability.

An object of the present inventive concepts is not limited to the mentioned above, and other objects which have not been mentioned above will be clearly understood to those skilled in the art from the following description.

According to some embodiments of the present inventive concepts, a semiconductor device may comprise: a substrate that includes a first active pattern and a second active pattern; a first channel pattern on the first active pattern and a second channel pattern on the second active pattern, each of the first and second channel patterns including a first semiconductor pattern and a second semiconductor pattern that are vertically spaced apart from each other; a plurality of first source/drain patterns connected to the first channel pattern and spaced apart from each other in a first direction; a plurality of second source/drain patterns connected to the second channel pattern and spaced apart from each other in the first direction; a first inner gate electrode between neighboring ones of the first semiconductor patterns; a second inner gate electrode between neighboring ones of the second semiconductor patterns; a first inner gate spacer between the first inner gate electrode and a first source/drain pattern of the plurality of first source/drain patterns; and a second inner gate spacer between the second inner gate electrode and a second source/drain pattern of the plurality of second source/drain patterns. The first inner gate spacer may have a first thickness in the first direction. The second inner gate spacer may have a second thickness in the first direction. The first thickness may be greater than the second thickness.

According to some embodiments of the present inventive concepts, a semiconductor device may comprise: a substrate that includes a first active pattern and a second active pattern; a first channel pattern on the first active pattern and a second channel pattern on the second active pattern, each of the first and second channel patterns including a plurality of semiconductor patterns that are vertically spaced apart from each other; a plurality of first source/drain patterns connected to the first channel pattern; a plurality of second source/drain patterns connected to the second channel pattern; a first inner gate electrode between neighboring ones of the plurality of semiconductor patterns of the first channel pattern; a second inner gate electrode between neighboring ones of the plurality of semiconductor patterns of the second channel pattern; a first inner gate spacer between the first inner gate electrode and a neighboring one of the plurality of first source/drain patterns; and a second inner gate spacer between the second inner gate electrode and a neighboring one of the plurality of second source/drain patterns. At the same level, e.g., the same vertical level, a spacing distance between the first inner gate electrode and the first source/drain pattern may be greater than a spacing distance between the second inner gate electrode and the second source/drain pattern. A spacing distance may be defined as a distance in, for example, the first direction between a respective inner gate electrode and source/drain pattern.

According to some embodiments of the present inventive concepts, a semiconductor device may comprise: a substrate that includes a first active pattern and a second active pattern; a first channel pattern on the first active pattern and a second channel pattern on the second active pattern, each of the first and second channel patterns including a plurality of semiconductor patterns that are vertically spaced apart from each other; a plurality of first source/drain patterns connected to the first channel pattern; a plurality of second source/drain patterns connected to the second channel pattern; a first gate electrode on the plurality of semiconductor patterns of the first channel pattern, the first gate electrode including a first inner gate electrode between neighboring ones of the plurality of semiconductor patterns of the first channel pattern and a first outer gate electrode on an uppermost one of the plurality of semiconductor patterns of the first channel pattern; a second gate electrode on the plurality of semiconductor patterns of the second channel pattern, the second gate electrode including a second inner gate electrode between neighboring ones of the plurality of semiconductor patterns of the second channel pattern and a second outer gate electrode on an uppermost one of the plurality of semiconductor patterns of the second channel pattern; a first inner gate spacer between one first source/drain pattern of the plurality of first source/drain patterns and a lateral surface of the first inner gate electrode; and a second inner gate spacer between one second source/drain pattern of the plurality of second source/drain patterns and a lateral surface of the second inner gate electrode. A thickness of the first inner gate spacer may be in a range of about 2.5 nm to about 3 nm. A thickness of the second inner gate spacer may be in a range of about 1.5 nm to about 2 nm.

The first channel pattern may be disposed on the first active pattern in a second direction perpendicular to the first direction. The second direction may be perpendicular to a top surface of the substrate. The second channel pattern may be disposed on the second active pattern in the second direction. The first and second channel patterns may overlay the first and second active patterns, respectively, in, for example, the second direction. The first and second channel patterns may overlay a portion of the first and second active patterns, respectively, in, for example, the second direction. As each of the first and second channel patterns include first and second semiconductor patterns, the semiconductor device may comprise a plurality of first semiconductor patterns and a plurality of second semiconductor patterns. One or more of first source/drain patterns may be connected to each other through one or more of the first semiconductor patterns in, for example, the first direction. One or more of the second source/drain patterns may be connected to each other through one or more of the second semiconductor patterns in, for example, the first direction. The first inner gate electrode may be one of a plurality of inner gate electrodes. The first inner gate electrode may be between neighboring ones of the first semiconductor patterns in the first direction. The second inner gate electrode may be between neighboring ones of the second semiconductor patterns in the first direction. The first inner gate electrode may be one of a plurality of first inner gate electrodes between neighboring ones of the first semiconductor patterns in the first direction. The second inner gate electrode may be one of a plurality of second inner gate electrodes between neighboring ones of the second semiconductor patterns in the first direction. The first inner gate spacer may be between the first inner gate electrode and a first source/drain pattern in the first direction. The second inner gate spacer may be between the second inner gate electrode and a second source/drain pattern in the first direction. The described level may be refer to a plane in the second direction.

At least some of the above and other features of the disclosure are set out in the claims.

### BRIEF DESCRIPTION OF DRAWINGS

FIGS. 1, 2, and 3 illustrate conceptual views showing logic cells of a semiconductor device according to some example embodiments of the present inventive concepts.
FIG. 4 illustrates a plan view showing a semiconductor device according to some example embodiments of the present inventive concepts.
FIGS. 5A, 5B, 5C, and 5D illustrate cross-sectional views respectively taken along lines A-A', B-B', C-C', and D-D' of FIG. 4.
FIGS. 6A and 6B illustrate enlarged views respectively showing section M of FIG. 5A and section N of FIG. 5B according to some example embodiments of the present inventive concepts.
FIGS. 7A and 7B illustrate enlarged views respectively showing section M of FIG. 5A and section N of FIG. 5B according to some example embodiments of the present inventive concepts.
FIGS. 8A and 8B illustrate enlarged views respectively showing section M of FIG. 5A and section N of FIG. 5B according to some example embodiments of the present inventive concepts.
FIGS. 9A to 14C illustrate cross-sectional views showing a method of fabricating a semiconductor device according to some example embodiments of the present inventive concepts.
FIGS. 15A to 17B illustrate enlarged views showing a method of forming section M of FIG. 5A and section N of FIG. 5B according to some example embodiments of the present inventive concepts.
FIGS. 18A to 19B illustrate enlarged views showing a method of forming section M of FIG. 5A and section N of FIG. 5B according to some example embodiments of the present inventive concepts.
FIGS. 20A and 20B illustrate enlarged views showing a method of forming section M of FIG. 5A and section N of FIG. 5B according to some example embodiments of the present inventive concepts.

### DETAILED DESCRIPTION OF EMBODIMENTS

The following will now describe in detail some embodiments of the present inventive concepts with reference to the accompanying drawings. Like reference characters refer to like elements throughout.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Terms such as "same," "equal," "planar," or "coplanar," as used herein when referring to orientation, layout, location, shapes, sizes, amounts, or other measures do not necessarily mean an exactly identical orientation, layout, location, shape, size, amount, or other measure, but are intended to encompass nearly identical orientation, layout, location, shapes, sizes, amounts, or other measures within acceptable variations that may occur, for example, due to manufacturing processes. The term "substantially" may be used herein to emphasize this meaning, unless the context or other statements indicate otherwise. For example, items described as "substantially the same," "substantially equal," or "substantially planar," may be exactly the same, equal, or planar, or may be the same, equal, or planar within acceptable variations that may occur, for example, due to manufacturing processes.

Although the figures described herein may be referred to using language such as "one embodiment," or "certain embodiments," these figures, and their corresponding descriptions are not intended to be mutually exclusive from other figures or descriptions, unless the context so indicates. Therefore, certain aspects from certain figures may be the same as certain features in other figures, and/or certain figures may be different representations or different portions of a particular embodiment.

It will be understood that, although the terms first, second, third etc. may be used herein to describe various elements, components, regions, layers and/or sections, these elements, components, regions, layers and/or sections should not be limited by these terms. Unless the context indicates otherwise, these terms are only used to distinguish one element, component, region, layer or section from another element, component, region, layer or section, for example as a naming convention. Thus, a first element, component, region, layer or section discussed below in one section of the specification could be termed a second element, component, region, layer or section in another section of the specification or in the claims without departing from the teachings of the present invention. In addition, in certain cases, even if a term is not described using "first," "second," etc., in the specification, it may still be referred to as "first" or "second" in a claim in order to distinguish different claimed elements from each other.

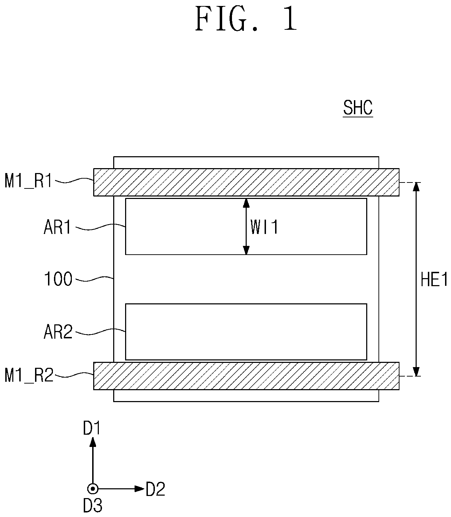

FIGS. 1, 2, and 3 illustrate conceptual views showing logic cells of a semiconductor device according to some example embodiments of the present inventive concepts.

Referring to FIG. 1, a single height cell SHC may be provided. For example, a substrate 100 may be provided thereon with a first power line M1_R1 and a second power line M1_R2. The first power line M1_R1 may be a path for providing a source voltage (VSS), for example, a ground voltage. The second power line M1_R2 may be a path for providing a drain voltage (VDD), for example, a power voltage.

The single height cell SHC may be defined between the first power line M1_R1 and the second power line M1_R2. The single height cell SHC may include one first active region AR1 and one second active region AR2. One of the first and second active regions AR1 and AR2 may be a PMOSFET region, and the other of the first and second active regions AR1 and AR2 may be an NMOSFET region. For example, the single height cell SHC may have a complementary metal oxide semiconductor (CMOS) structure provided between the first power line M1_R1 and the second power line M1_R2. For example, the first active region AR1 may be an NMOSFET region, and the second active region AR2 may be a PMOSFET region.

The first and second active regions AR1 and AR2 may extend to have a width WI1 in a first direction D1. The first and second active regions AR1 and AR2 may extend lengthwise in a second direction D2. A first height HE1 may be defined as a length in the first direction D1 of the single height cell SHC. The first height HE1 may be substantially the same as a distance (e.g., pitch) between the first power line M1_R1 and the second power line M1_R2. For example, the first height HE1 may be substantially the same as a distance (e.g., pitch) between the same reference point on each of the first power line M1_R1 and the second power line M1_R2.

In this description, the first direction D1 may be defined to refer to one direction parallel to a top surface of the substrate 100. A second direction D2 may be defined to refer to one direction parallel to the top surface of the substrate 100 and orthogonal to the first direction D1. A third direction D3 may be defined to refer to one direction perpendicular to the top surface of the substrate 100. While the directions D1, D2, D3 have been introduced as first, second and third directions, respectively, this designations may be varied. For example, the second direction D2 may be referred to as a first direction. Similarly, the third direction D3 may be referred to as a second direction.

The single height cell SHC may constitute one logic cell. In this description, the logic cell may mean a logic device, such as AND, OR, XOR, XNOR, and inverter, that performs a specific function. For example, the logic cell may include transistors for constituting a logic device, and may also include wiring lines that connect the transistors to each other.

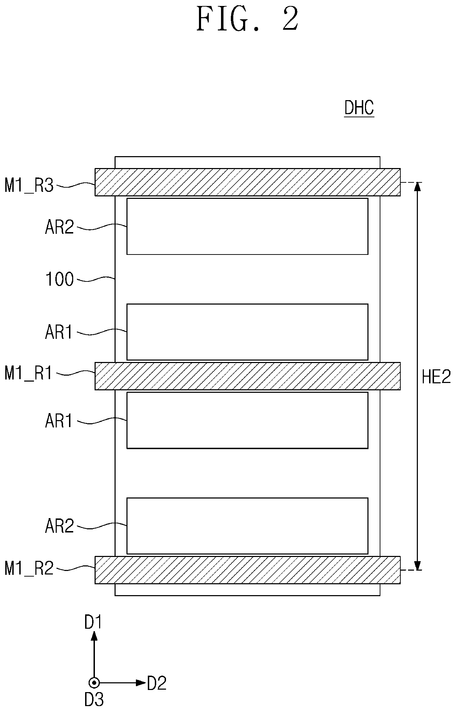

Referring to FIG. 2, a double height cell DHC may be provided. For example, a substrate 100 may be provided thereon with a first power line M1_R1, a second power line M1_R2, and a third power line M1_R3. The first power line M1_R1 may be disposed between the second power line M1_R2 and the third power line M1_R3. The third power line M1_R3 may be a path for providing a source voltage (VSS).

The double height cell DHC may be defined between the second power line M1_ R2 and the third power line M1_R3. The double height cell DHC may include two first active regions AR1 and two second active regions AR2.

One of the two second active regions AR2 may be adjacent to the second power line M1_R2. The other of the two second active regions AR2 may be adjacent to the third power line M1_R3. The two first active regions AR1 may be adjacent to the first power line M1 R1. When viewed in plan, the first power line M1_R1 may be disposed between the two first active regions AR1.

A second height HE2 may be defined to indicate a length in the first direction D1 of the double height cell DHC. The second height HE2 may be about twice the first height HE1 of FIG. 1. The two first active regions AR1 of the double height cell DHC may be collectively connected to act as one active region.

In the present inventive concepts, the double height cell DHC shown in FIG. 2 may be defined as a multi-height cell. Although not shown, in some embodiments, the multi-height cell may include a triple height cell whose cell height is about three times that of the single height cell SHC.

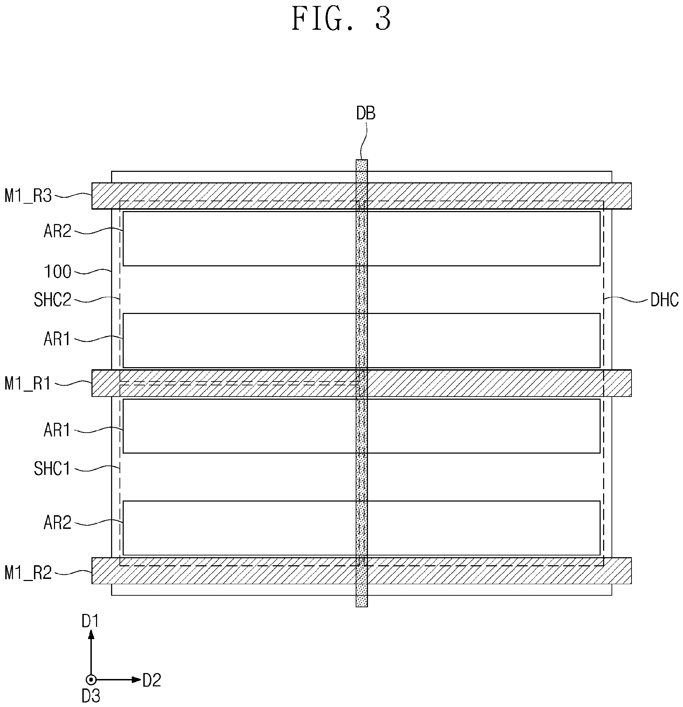

Referring to FIG. 3, a substrate 100 may be provided thereon with a first single height cell SHC1, a second single height cell SHC2, and a double height cell DHC that are two-dimensionally disposed. The first single height cell SHC1 may be disposed between a first power line M1_R1 and a second power line M1_R2. The second single height cell SHC2 may be disposed between the first power line M1_R1 and a third power line M1_R3. The second single height cell SHC2 may be adjacent in a first direction D1 to the first single height cell SHC1.

The double height cell DHC may be disposed between the second power line M1_R2 and the third power line M1_R3. The double height cell DHC may be adjacent in a second direction D2 to the first and second single height cells SHC1 and SHC2.

A separation structure DB may be provided between the first single height cell SHC1 and the double height cell DHC and between the second single height cell SHC2 and the double height cell DHC. The separation structure DB may electrically separate an active region of the double height cell DHC from an active region of each of the first and second single height cells SHC1 and SHC2.

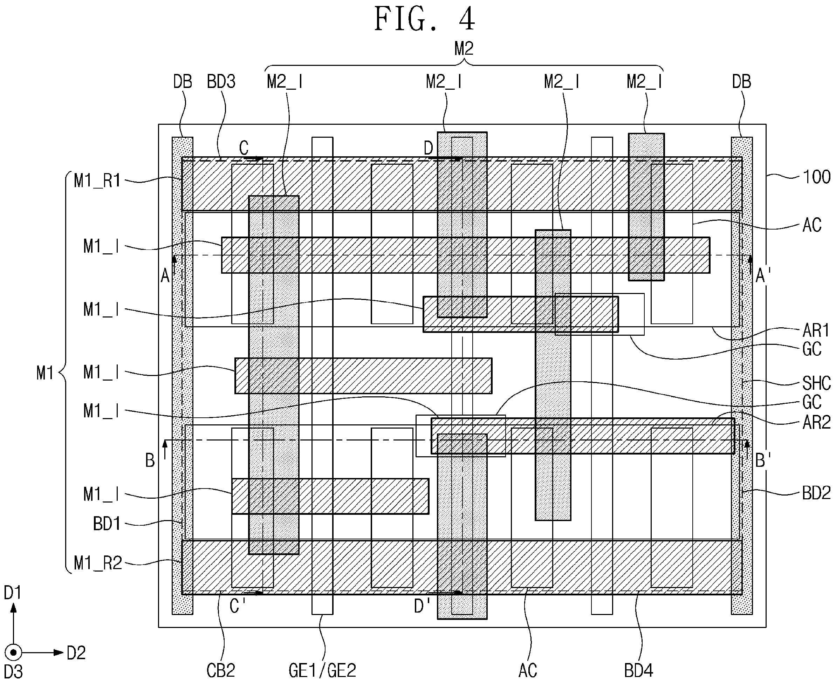

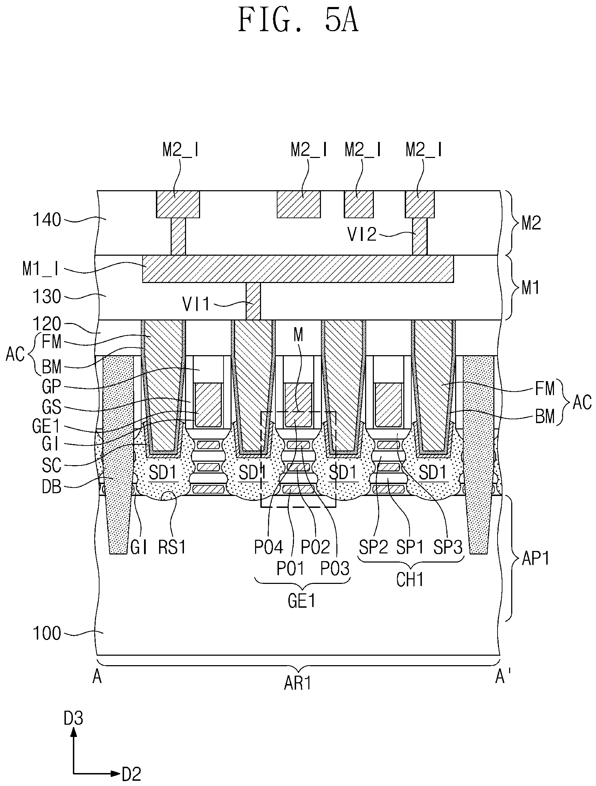

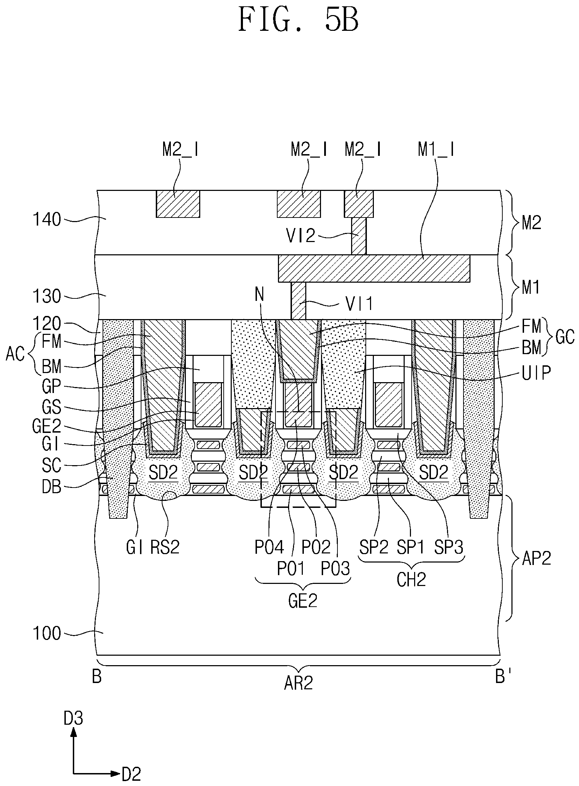

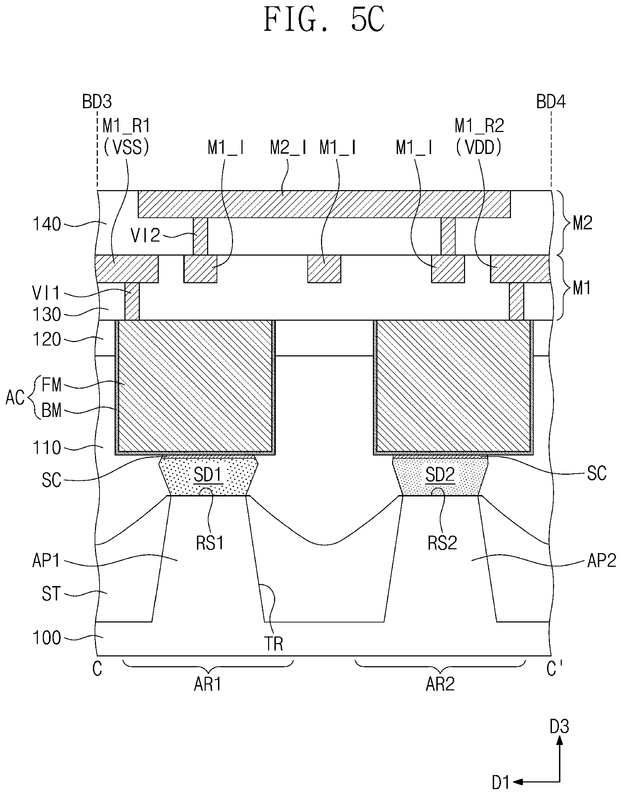

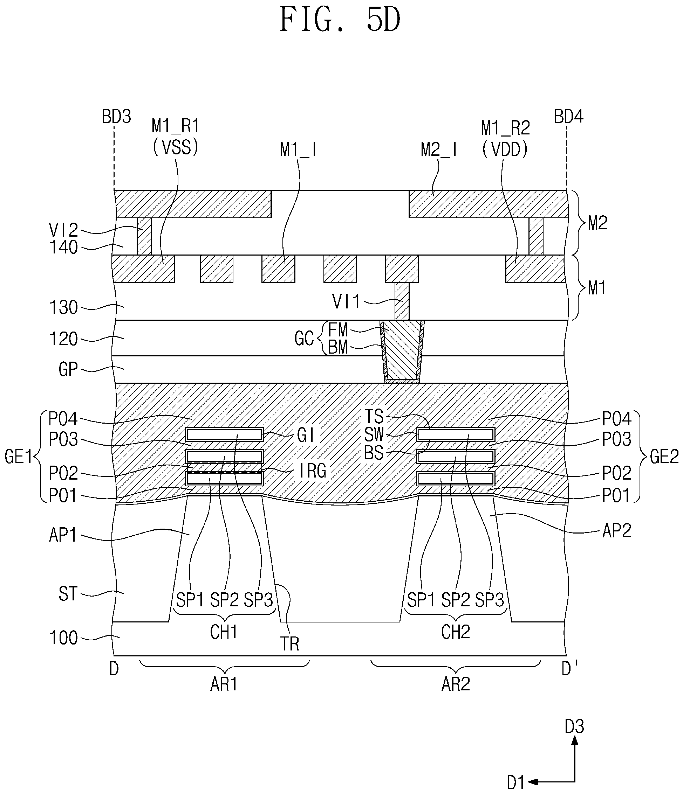

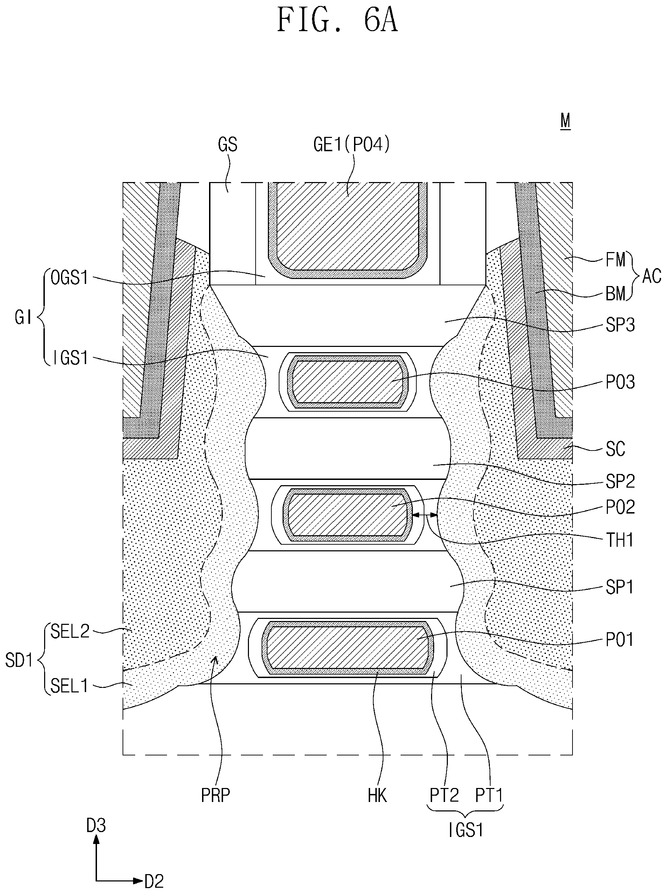

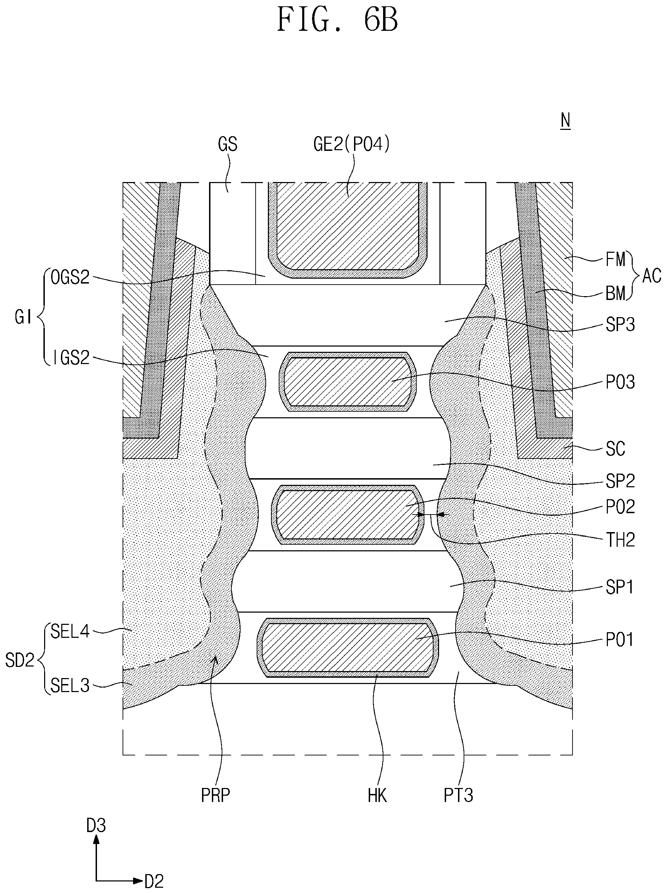

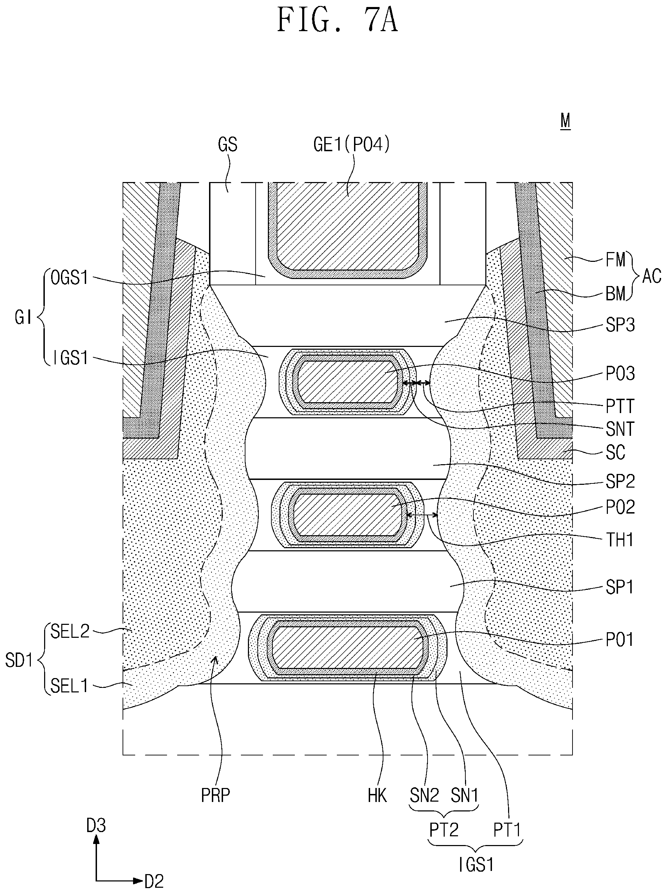

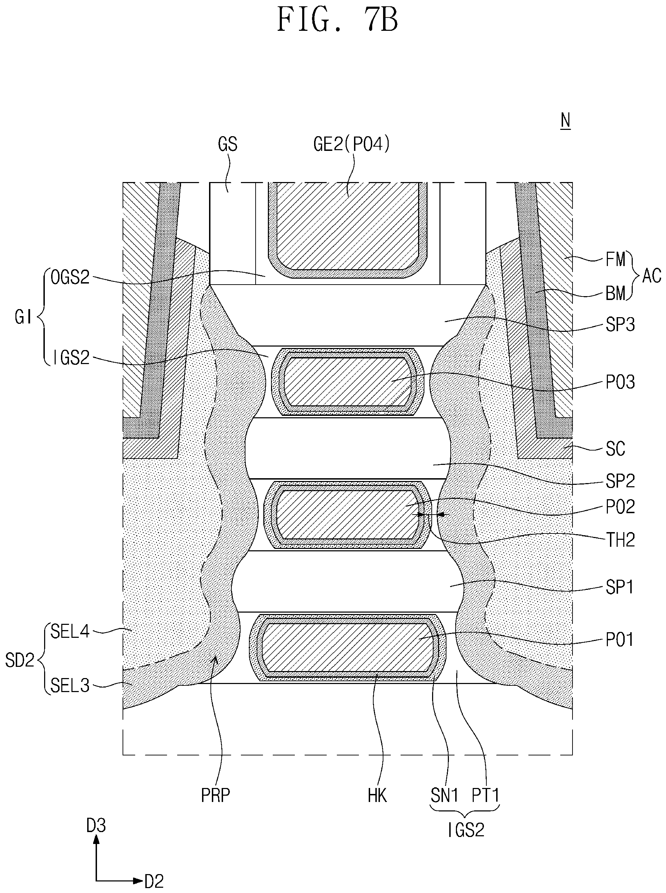

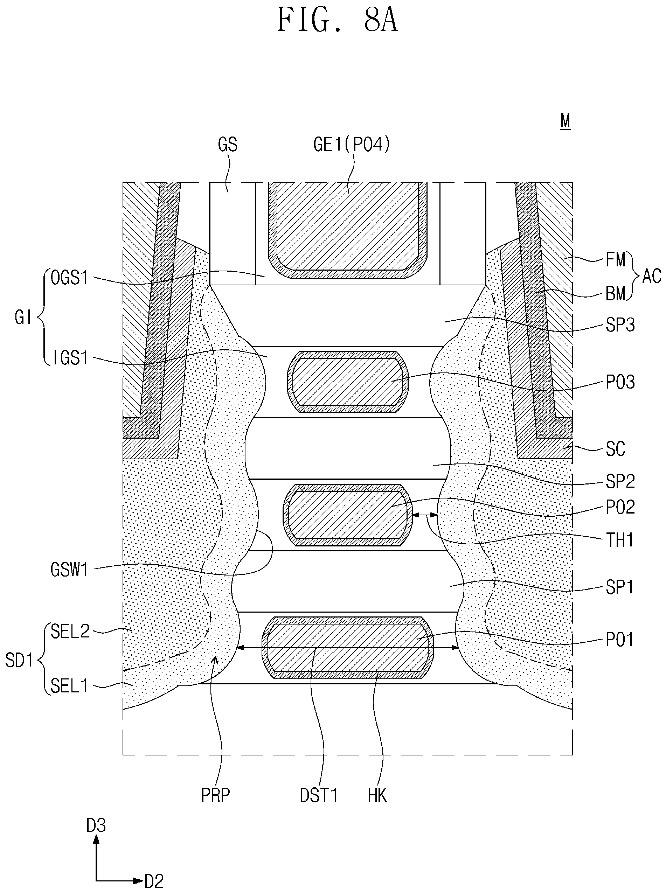

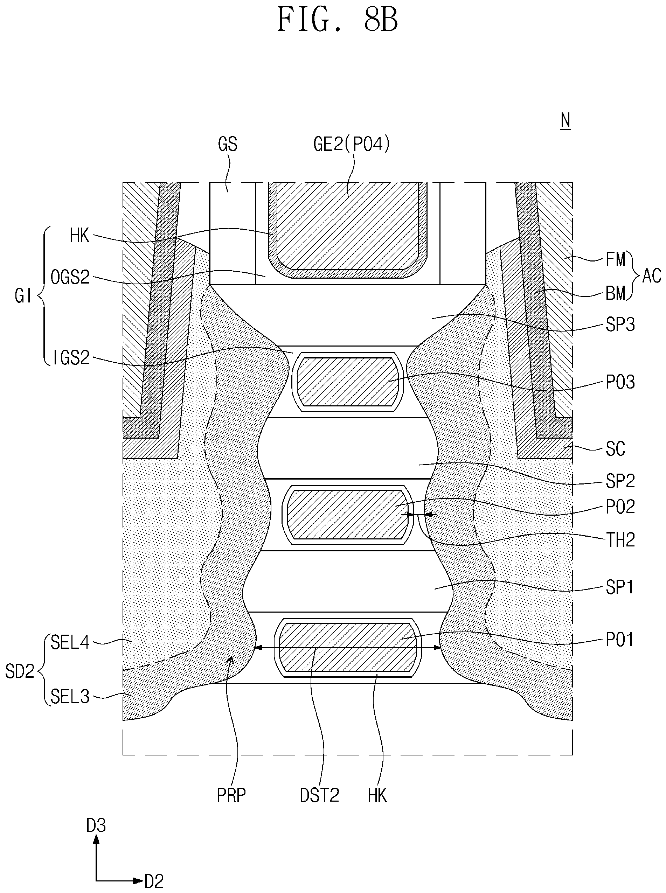

FIG. 4 illustrates a plan view showing a semiconductor device according to some embodiments of the present inventive concepts. FIGS. 5A, 5B, 5C, and 5D illustrate cross-sectional views respectively taken along lines A-A', B-B', C-C', and D-D' of FIG. 4. A semiconductor device depicted in FIGS. 4 and 5A to 5D is a detailed example of the single height cell SHC shown in FIG. 1. FIGS. 6A and 6B illustrate enlarged views respectively showing section M of FIG. 5A and section N of FIG. 5B according to some embodiments of the present inventive concepts. FIGS. 7A and 7B illustrate enlarged views respectively showing section M of FIG. 5A and section N of FIG. 5B according to some embodiments of the present inventive concepts. FIGS. 8A and 8B illustrate enlarged views respectively showing section M of FIG. 5A and section N of FIG. 5B according to some embodiments of the present inventive concepts.

Referring to FIGS. 4 and 5A to 5D, a single height cell SHC may be provided on a substrate 100. The single height cell SHC may be provided thereon with logic transistors included in a logic circuit. The substrate 100 may be a compound semiconductor substrate or a semiconductor substrate including silicon, germanium, or silicon-germanium. For example, the substrate 100 may be a silicon substrate.

The substrate 100 may include a first active region AR1 and a second active region AR2. Each of the first and second active regions AR1 and AR2 may extend lengthwise in a second direction D2. In an embodiment, the first active region AR1 may be an NMOSFET region, and the second active region AR2 may be a PMOSFET region.

A first active pattern AP1 and a second active pattern AP2 may be defined by trenches TR formed on an upper portion of the substrate 100. The first active pattern AP1 may be provided on the first active region AR1, and the second active pattern AP2 may be provided on the second active region AR2. The first and second active patterns AP1 and AP2 may extend lengthwise in the second direction D2. The first and second active patterns AP1 and AP2 may be vertically protruding portions of the substrate 100. For example, the first and second active patterns AP1 and AP2 may be either part of the substrate 100 (e.g., being formed by etching) or formed on the substrate 100 (e.g., epitaxially grown).

A device isolation layer ST may be provided on the substrate 100. The device isolation layer ST may fill the trenches TR. The device isolation layer ST may include a silicon oxide layer. The device isolation layer ST may not cover any of first and second channel patterns CH1 and CH2 which will be discussed below.

The first channel pattern CH1 may be provided on the first active pattern AP1. A second channel pattern CH2 may be provided on the second active pattern AP2. Each of the first and second channel patterns CH1 and CH2 may include a first semiconductor pattern SP1, a second semiconductor pattern SP2, and a third semiconductor pattern SP3 that are sequentially stacked. The first, second, and third semiconductor patterns SP1, SP2, and SP3 may be spaced apart from each other in a vertical direction (or a third direction D3).

Each of the first, second, and third semiconductor patterns SP1, SP2, and SP3 may include silicon (Si), germanium (Ge), or silicon-germanium (SiGe). For example, each of the first, second, and third semiconductor patterns SP1, SP2, and SP3 may include crystalline silicon. In an embodiment of the present inventive concepts, the first, second, and third semiconductor patterns SP1, SP2, and SP3 may be stacked nano-sheets.

A plurality of first source/drain patterns SD1 may be provided on the first active pattern AP1. A plurality of first recesses RS 1 may be formed on an upper portion of the first active pattern AP1. The first source/drain patterns SD1 may be correspondingly provided in the first recesses RS 1. The first source/drain patterns SD1 may be impurity regions of a first conductivity type (e.g., n-type). The first channel pattern CH1 may be interposed between a pair of first source/drain patterns SD1. The first channel pattern CH1 may be interposed between a pair of the first source/drain patterns SD1 in the second direction D2. For example, the pair of first source/drain patterns SD1 may be connected through the stacked first, second, and third semiconductor patterns SP1, SP2, and SP3.

A plurality of second source/drain patterns SD2 may be provided on the second active pattern AP2. A plurality of second recesses RS2 may be formed on an upper portion of the second active pattern AP2. The second source/drain patterns SD2 may be correspondingly provided in the second recesses RS2. The second source/drain patterns SD2 may be impurity regions of a second conductivity type (e.g., p-type). The second channel pattern CH2 may be interposed between a pair of second source/drain patterns SD2. The second channel pattern CH2 may be interposed between a pair of the second source/drain patterns SD2 in the second direction D2. For example, the pair of second source/drain patterns SD2 may be connected through the stacked first, second, and third semiconductor patterns SP1, SP2, and SP3.

The first and second source/drain patterns SD1 and SD2 may be epitaxial patterns formed by a selective epitaxial growth (SEG) process. For example, each of the first and second source/drain patterns SD1 and SD2 may have a top surface higher than that of the third semiconductor pattern SP3. For another example, at least one of the first and second source/drain patterns SD1 and SD2 may have a top surface at substantially the same level as that of a top surface of the third semiconductor pattern SP3.

In an embodiment of the present inventive concepts, the first source/drain patterns SD1 may include the same semiconductor element (e.g., Si) as that of the substrate 100. The second source/drain patterns SD2 may include a semiconductor element (e.g., SiGe) whose lattice constant is greater than that of a semiconductor element of the substrate 100. Therefore, a pair of second source/drain patterns SD2 may provide the second channel pattern CH2 with a compressive stress.

Each of the first and second source/drain patterns SD 1 and SD2 may have an uneven embossing shape at a sidewall thereof. For example, each of the first and second source/drain patterns SD1 and SD2 may have a wavy profile at the sidewall thereof. The sidewalls of the first and second source/drain patterns SD1 and SD2 may protrude toward first, second, and third inner gate electrodes PO1, PO2, and PO3 of first and second gate electrodes GE1 and GE2 which will be discussed below.

First and second gate electrodes GE1 and GE2 may be provided on the first and second channel patterns CH1 and CH2. For example, portions of the first gate electrode GE1 may be interspersed with portions of the first channel layer CH1 as will be described. Portions of the second gate electrode GE2 may be interspersed with portions of the second channel layer CH2 as will be described. The first and second gate electrodes GE1 and GE2 may extend lengthwise in a first direction D1, while running across the first and second channel patterns CH1 and CH2. The first and second gate electrodes GE1 and GE2 may vertically overlap the first and second channel patterns CH1 and CH2, respectively. For example, portions of the first and second gate electrodes GE1 and GE2 may vertically overlap portions the first and second channel patterns CH1 and CH2, respectively. The first and second gate electrodes GE1 and GE2 may be arranged in the second direction D2 at a first pitch.

Each of the first and second gate electrodes GE1 and GE2 may include a first inner gate electrode PO1 interposed between the first semiconductor pattern SP1 and the active pattern AP1 or AP2, a second inner gate electrode PO2 interposed between the first semiconductor pattern SP1 and the second semiconductor pattern SP2, a third inner gate electrode PO3 interposed between the second semiconductor pattern SP2 and the third semiconductor pattern SP3, and an outer gate electrode PO4 on the third semiconductor pattern SP3. In this context, interposed may refer to being between two elements in the third direction D3.

Referring to FIG. 5D, each of the first and second gate electrodes GE1 and GE2 may be provided on a top surface TS, a bottom surface BS, and opposite sidewalls SW of each of the first, second, and third semiconductor patterns SP1, SP2, and SP3. In this sense, a transistor according to the present embodiment may be a three-dimensional field effect transistor (e.g., MBCFET or GAAFET) in which the first and second gate electrodes GE1 and GE2 three-dimensionally surround the first and second channel patterns CH1 and CH2.

Referring back to FIGS. 5A to 5D, a pair of gate spacers GS may be disposed on opposite sidewalls of the outer gate electrode PO4 of each of the first and second gate electrodes GE1 and GE2, e.g., in the second direction D2. The gate spacers GS may extend in the first direction D1 along the first and second gate electrodes GE1 and GE2. The gate spacers GS may have their top surfaces higher than those of the first and second gate electrodes GE1 and GE2 e.g., in the third direction D3. The top surfaces of the gate spacers GS may be coplanar with that of a first interlayer dielectric layer 110 which will be discussed below. In an embodiment, the gate spacers GS may include at least one selected from SiCN, SiCON, and SiN. In another embodiment, the gate spacers GS may include a multiple layer formed of at least two selected from SiCN, SiCON, and SiN.

A gate capping pattern GP may be provided on each of the first and second gate electrodes GE1 and GE2. The gate capping pattern GP may extend lengthwise in the first direction D1 along the first and second gate electrodes GE1 and GE2. The gate capping pattern GP may contact upper surfaces of the first and second gate electrodes GE1 and GE2. The gate capping pattern GP may include a material having an etch selectivity with respect to first and second interlayer dielectric layers 110 and 120 which will be discussed below. For example, the gate capping pattern GP may include at least one selected from SiON, SiCN, SiCON, and SiN.

A gate dielectric layer GI may be interposed between the first gate electrode GE1 and the first channel pattern CH1 and between the second gate electrode GE2 and the second channel pattern CH2, e.g., in the third direction D3. The gate dielectric layer GI may cover the top surface TS, the bottom surface BS, and the opposite sidewalls SW of each of the first, second, and third semiconductor patterns SP1, SP2, and SP3. The gate dielectric layer GI may cover a top surface of the device isolation layer ST below the first and second gate electrodes GE1 and GE2. For example, the gate dielectric layer GI may contact the top surface TS, the bottom surface BS, and the opposite sidewalls SW of each of the first, second, and third semiconductor patterns SP1, SP2, and SP3, and the top surface of the device isolation layer ST below the first and second gate electrodes GE1 and GE2.

As shown in FIG. 6A, the gate dielectric layer GI may include a first inner gate spacer IGS1 between the first, second, and third semiconductor patterns SP1, SP2, and SP3 of the first channel pattern CH1 and the first, second, and third inner gate electrodes PO1, PO2, and PO3 of the first gate electrode GE1 e.g., in the third direction D3, and may also include a first outer gate spacer OGS1 between the third semiconductor pattern SP3 and the outer gate electrode PO4 of the first gate electrode GE1, e.g., in the third direction D3.

As shown in FIG. 6B, the gate dielectric layer GI may include a second inner gate spacer IGS2 between the first, second, and third semiconductor patterns SP1, SP2, and SP3 of the second channel pattern CH2 and the first, second, and third inner gate electrodes PO1, PO2, and PO3 of the second gate electrode GE2, e.g., in the third direction D3, and may also include a second outer gate spacer OGS2 between the third semiconductor pattern SP3 and the outer gate electrode PO4 of the second gate electrode GE2, e.g., in the third direction D3.

As illustrated in FIG. 6A, the first inner gate spacer IGS1 may have a first thickness TH1. In this description, the first thickness TH1 may be a thickness in the second direction D2 of the first inner gate spacer IGS 1 on lateral surfaces of the first, second, and third inner gate electrodes PO1, PO2, and PO3 of the first gate electrode GE1, and may correspond to a minimum spacing distance between the first source/drain pattern SD1 and a high-k dielectric layer HK which will be discussed below.

As illustrated in FIG. 6B, the second inner gate spacer IGS2 may have a second thickness TH2. In this description, the second thickness TH2 may be a thickness in the second direction D2 of the second inner gate spacer IGS2 on lateral surfaces of the first, second, and third inner gate electrodes PO1, PO2, and PO3 of the second gate electrode GE2, and may correspond to a minimum spacing distance between the second source/drain pattern SD2 and a high-k dielectric layer HK which will be discussed below.

As shown in FIGS. 6A and 6B, the first thickness TH1 may be greater than the second thickness TH2. For example, the first thickness TH1 may range from about 2.5 nm to about 3 nm, and the second thickness TH2 may range from about 1.5 nm to about 2 nm. As the first thickness TH1 is greater than the second thickness TH2, a minimum spacing distance between the first source/drain pattern SD1 and the first, second, and third inner gate electrodes PO1, PO2, and PO3 of the first gate electrode GE1 may be greater than a minimum spacing distance between the second source/drain pattern SD2 and the first, second, and third inner gate electrodes PO1, PO2, and PO3 of the second gate electrode GE2.

As depicted in FIG. 6A, the first inner gate spacer IGS 1 may include a first dielectric pattern PT1 and a second dielectric pattern PT2 on the first dielectric pattern PT1. While the first and second dielectric patterns PT1, PT2 have been referred to as such, these may be interchanged with the first dielectric pattern PT1 being referred to as a second dielectric pattern and the second dielectric patterns PT2 being referred to as a first dielectric pattern. The first dielectric pattern PT1 may surround, e.g., in the second and third directions, the second dielectric pattern PT2. The first dielectric pattern PT1 may be disposed on the second dielectric pattern PT2 in the second and/or third directions. The second dielectric pattern PT2 may contact the first dielectric pattern PT1. The first dielectric pattern PT1 may be in contact with the first source/drain pattern SD1. The second dielectric pattern PT2 may surround, e.g., in the second and third directions, the first, second, and third inner gate electrodes PO1, PO2, and PO3 of the first gate electrode GE1. The second dielectric pattern PT2 may contact the high-k dielectric layer HK. The first dielectric pattern PT1 may be disposed spaced apart from the first, second, and third inner gate electrodes PO1, PO2, and PO3. The second dielectric pattern PT2 may be disposed spaced apart from the first source/drain pattern SD1. The first dielectric pattern PT1 and the second dielectric pattern PT2 may include, for example, silicon oxide.

As depicted in FIG. 6B, the second inner gate spacer IGS2 may include a third dielectric pattern PT3. For example, the third dielectric pattern PT3 may be interposed between adjacent ones of the second source/drain patterns SD2, and the second inner gate spacer IGS2 may surround the first, second, and third inner gate electrodes PO1, PO2, and PO3 of the second gate electrode GE2. The third dielectric pattern PT3 may contact the high-k dielectric layer HK and the second source/drain patterns SD2.

Each of the first and second outer gate spacers OGS 1 and OGS2 may be provided on a bottom surface and lateral surfaces of the outer gate electrode PO4. Each of the first and second outer gate spacers OGS1 and OGS2 may extend to a bottom surface of the gate capping pattern (see, e.g., gate capping pattern GP of FIGS. 5A and 5B) that covers a top surface of the outer gate electrode PO4.

A high-k dielectric layer HK may be interposed between the gate dielectric layer GI and each of the first and second gate electrodes GE1 and GE2. The high-k dielectric layer HK may include a high-k dielectric material whose dielectric constant is greater than that of a silicon oxide layer. For example, the high-k dielectric material may be formed of or include at least one selected from hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

In some embodiments, a semiconductor device of the present inventive concepts may include a negative capacitance field effect transistor that uses a negative capacitor. For example, the gate dielectric layer GI may include a ferroelectric material layer that has ferroelectric properties and a paraelectric material layer that has paraelectric properties.

The ferroelectric material layer may have a negative capacitance, and the paraelectric material layer may have a positive capacitance. For example, when two or more capacitors are connected in series, and when each capacitor has a positive capacitance, an overall capacitance may be reduced to be less than the capacitance of each capacitor. In contrast, when at least one of two or more capacitors connected in series has a negative capacitance, an overall capacitance may have a positive value that is increased to be greater than an absolute value of the capacitance of each capacitor.

When the ferroelectric material layer having a negative capacitance is connected in series to the paraelectric material layer having a positive capacitance, there may be an increase in overall capacitance of the ferroelectric and paraelectric material layers that are connected in series. The increase in overall capacitance may be used to allow a transistor including the ferroelectric material layer to have a sub-threshold swing of less than about 60 mV/decade at room temperature.

The ferroelectric material layer may have ferroelectric properties. The ferroelectric material layer may include, for example, at least one selected from hafnium oxide, hafnium zirconium oxide, barium strontium titanium oxide, and lead zirconium titanium oxide. For example, the hafnium zirconium oxide may be a material in which hafnium oxide is doped with zirconium (Zr). For another example, the hafnium zirconium oxide may be a compound of hafnium (Hf), zirconium (Zr), and oxygen (O).

The ferroelectric material layer may further include impurities doped therein. For example, the impurities may include at least one selected from aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). The type of impurities included in the ferroelectric material layer may be changed depending on what ferroelectric material is included in the ferroelectric material layer.

When the ferroelectric material layer includes hafnium oxide, the ferroelectric material layer may include at least one of impurities such as gadolinium (Gd), silicon (Si), zirconium (Zr), aluminum (Al), and yttrium (Y).

When the impurities are aluminum (Al), the ferroelectric material layer may include about 3 to 8 atomic percent aluminum. In this description, the ratio of impurities may be a ratio of aluminum to the sum of hafnium and aluminum.

When the impurities are silicon (Si), the ferroelectric material layer may include about 2 to about 10 atomic percent silicon. When the impurities are yttrium (Y), the ferroelectric material layer may include about 2 to about 10 atomic percent yttrium. When the impurities are gadolinium (Gd), the ferroelectric material layer may include about 1 to about 7 atomic percent gadolinium. When the impurities are zirconium (Zr), the ferroelectric material layer may include about 50 to about 80 atomic percent zirconium. In this description, the ratio of impurities may be a ratio of the impurities to the sum of ferroelectric material and the impurities.

The paraelectric material layer may have paraelectric properties. The paraelectric material layer may include, for example, at least one selected from silicon oxide and high-k metal oxide. The metal oxide included in the paraelectric material layer may include, for example, one or more of hafnium oxide, zirconium oxide, and aluminum oxide, but the present inventive concepts are not limited thereto.

The ferroelectric and paraelectric material layers may include the same material. The ferroelectric material layer may have ferroelectric properties, but the paraelectric material layer may not have ferroelectric properties. For example, when the ferroelectric material layer and the paraelectric material layer include hafnium oxide, the hafnium oxide included in the ferroelectric material layer may have a crystal structure different from that of the hafnium oxide included in the paraelectric material layer.

The ferroelectric material layer may have a thickness having ferroelectric properties. The thickness of the ferroelectric material layer may range, for example, from about 0.5 nm to about 10 nm, but the present inventive concepts are not limited thereto. For example, the ferroelectric material layer may have a thickness that exhibits ferroelectric properties, and that thickness may range from about 0.5 nm to about 10 nm. Because ferroelectric materials have their own critical thickness that exhibits ferroelectric properties, the thickness of the ferroelectric material layer may depend on ferroelectric material.

The first source/drain pattern SD1 may include protrusions PRP that correspondingly protrude toward the first, second, and third inner gate electrodes PO1, PO2, and PO3 of the first gate electrode GE1. The first source/drain pattern SD1 may include a first semiconductor layer SEL1 and a second semiconductor layer SEL2 on the first semiconductor layer SEL1. The second semiconductor layer SEL2 may contact the first semiconductor layer SEL1. In an embodiment, when the first source/drain pattern SD1 is n-type, the first semiconductor layer SEL1 may include the same material, such as silicon (Si), as that of the second semiconductor layer SEL2. However, a concentration of n-type impurities (e.g., phosphorus or arsenic) in the second semiconductor layer SEL2 may be greater than a concentration of n-type impurities in the first semiconductor layer SEL1.

The second source/drain pattern SD2 may include protrusions PRP that correspondingly protrude toward the first, second, and third inner gate electrodes PO1, PO2, and PO3 of the second gate electrode GE2. The second source/drain pattern SD2 may include a third semiconductor layer SEL3 and a fourth semiconductor layer SEL4 on the third semiconductor layer SEL3. The fourth semiconductor layer SEL4 may contact the third semiconductor layer SEL3. In an embodiment, when the second source/drain pattern SD2 is p-type, the third semiconductor layer SEL3 may include the same semiconductor material, such as silicon-germanium (SiGe), as that of the fourth semiconductor layer SEL4. However, a germanium concentration of the fourth semiconductor layer SEL4 may be greater than that of the third semiconductor layer SEL3. In addition, a concentration of p-type impurities (e.g., boron) in the fourth semiconductor layer SEL4 may be greater than a concentration of p-type impurities in the third semiconductor layer SEL3.

FIGS. 7A and 7B illustrate enlarged views respectively showing section M of FIG. 5A and section N of FIG. 5B according to some embodiments of the present inventive concepts. A duplicate explanation of FIGS. 6A and 6B will be omitted, and a difference will be mainly described.

Referring to FIGS. 7A and 7B, the first inner gate spacer IGS1 may include a first dielectric pattern PT1 and a second dielectric pattern PT2 on the first dielectric pattern PT1. The first dielectric pattern PT1 may be in contact with the first source/drain pattern SD1. The first dielectric pattern PT1 may surround the second dielectric pattern PT2, e.g., in the second and third directions, and may contact the second dielectric pattern PT2. The second dielectric pattern PT2 may surround, e.g., in the second and third directions, the first, second, and third inner gate electrodes PO1, PO2, and PO3 of the first gate electrode GE1. The second dielectric pattern PT2 may be disposed in contact with the high-k dielectric layer HK and spaced apart from the first source/drain pattern SD1.

For example, the second dielectric pattern PT2 may include a first protective pattern SN1 in contact with the first dielectric pattern PT1 and a second protective pattern SN2 on the first protective pattern SN1. The first protective pattern SN1 may surround the second protective pattern SN2 and may contact the second protective pattern SN2. The first protective pattern SN1 may be interposed between the second protective pattern SN2 and the first dielectric pattern PT1. The second protective pattern SN2 may be interposed between the first protective pattern SN1 and the first, second, and third inner gate electrodes PO1, PO2, and PO3. The second protective pattern SN2 may be in contact with the first, second, and third inner gate electrodes PO1, PO2, and PO3 in, for example, the second and third directions. While the first protective pattern SN1 and the second protective pattern SN2 have been to referred to as such, these may be interchanged with the first protective pattern PT1 being referred to as a second protective pattern, and the second protective pattern PT2 being referred to as a first protective pattern.

A thickness PTT in the second direction D2 of the first dielectric pattern PT1 may be about 40% to about 50% of the first thickness TH1 of the first inner gate spacer IGS 1. A thickness SNT in the second direction D2 of the second dielectric pattern PT2 may be about 50 % to about 60% of the first thickness TH1 of the first inner gate spacer IGS 1. A sum of the thickness PTT in the second direction D2 of the first dielectric pattern PT1 and the thickness SNT in the second direction D2 of the second dielectric pattern PT2 may be substantially the same as the first thickness TH1 of the first inner gate spacer IGS 1.

The first dielectric pattern PT1 and the second dielectric pattern PT2 may include different materials from each other. The first dielectric pattern PT1 may include silicon oxide, such as SiO2. The second dielectric pattern PT2 may include silicon nitride, such as SiN and SiCN.

As shown in FIG. 7B, the second inner gate spacer IGS2 may include a first dielectric pattern PT1 and a first protective pattern SN1 on the first dielectric pattern PT 1. For example, differently from the first inner gate spacer IGS 1, the second inner gate spacer IGS2 may be configured such that the first protective pattern SN1 may be in contact with the high-k dielectric layer HK. Differently from that shown, according to an embodiment of the present inventive concepts, the first protective pattern SN1 may be omitted from the second inner gate spacer IGS2.

FIGS. 8A and 8B illustrate enlarged views respectively showing section M of FIG. 5A and section N of FIG. 5B. A duplicate explanation of FIGS. 6A and 6B will be omitted, and a difference will be mainly described.

Referring to FIGS. 8A and 8B, the first inner gate spacer IGS1 may be interposed between the first source/drain pattern SD1 and the first, second, and third inner gate electrodes PO1, PO2, and PO3 of the first gate electrode GE1. The second inner gate spacer IGS2 may be interposed between the second source/drain pattern SD2 and the first, second, and third inner gate electrodes PO1, PO2, and PO3 of the second gate electrode GE2.

The first source/drain patterns SD1 may be spaced apart at a first length DST1 from each other in the second direction D2. The second source/drain patterns SD2 may be spaced apart at a second length DST2 from each other in the second direction D2. The first length DST1 may be greater than the second length DST2. In this description, the first length DST1 and the second length DST2 may respectively refer to a spacing distance measured along the second direction D2 at the same level, e.g., the same level in the third direction D3, between the first source/drain patterns SD1 and a spacing distance measured along the second direction D2 at the same level between the second source/drain patterns SD2, e.g., the same level in the third direction D3. The first inner gate spacer IGS1 and the second inner gate spacer IGS2 may include at least one selected from silicon oxide, silicon nitride, and silicon oxynitride.

Referring back to FIGS. 4 and 5A to 5D, each of the first and second gate electrodes GE1 and GE2 may include a first metal pattern and a second metal pattern on the first metal pattern. The first metal pattern may be provided on the gate dielectric layer GI and may be adjacent to the first, second, and third semiconductor patterns SP1, SP2, and SP3. The first metal pattern may include a work-function metal that controls a threshold voltage of a transistor. A thickness and composition of the first metal pattern may be adjusted to achieve a desired threshold voltage of a transistor. The first, second, and third inner gate electrodes PO1, PO2, and PO3 of each of the first and second gate electrodes GE1 and GE2 may be formed of the first metal pattern or a work-function metal.

The first metal pattern may include a metal nitride layer. For example, the first metal pattern may include nitrogen (N) and at least one metal selected from titanium (Ti), tantalum (Ta), aluminum (Al), tungsten (W), and molybdenum (Mo). In addition, the first metal pattern may further include carbon (C). The first metal pattern may include a plurality of stacked work-function metal layers.

The second metal pattern may include a metal whose resistance is less than that of the first metal pattern. For example, the second metal pattern may include at least one metal selected from tungsten (W), aluminum (Al), titanium (Ti), and tantalum (Ta). The outer gate electrode PO4 of each of the first and second gate electrodes GE1 and GE2 may include a first metal pattern and a second metal pattern on the first metal pattern.

A first interlayer dielectric layer 110 may be provided on the substrate 100. The first interlayer dielectric layer 110 may cover the gate spacers GS and the first and second source/drain patterns SD1 and SD2. The first interlayer dielectric layer 110 may be provided thereon with a second interlayer dielectric layer 120 that covers the gate capping pattern GP. A third interlayer dielectric layer 130 may be provided on the second interlayer dielectric layer 120. A fourth interlayer dielectric layer 140 may be provided on the third interlayer dielectric layer 130. The fourth interlayer dielectric layer 140 may contact an upper surface of the third interlayer dielectric layer 130, the third interlayer dielectric layer 130 may contact an upper surface of the second interlayer dielectric layer 120, and the second interlayer dielectric layer 120 may contact an upper surface of the first interlayer dielectric layer 110. For example, the first to fourth interlayer dielectric layers 110 to 140 may include a silicon oxide layer.

The single height cell SHC may have a first boundary BD1 and a second boundary BD2 that are opposite to each other in the second direction D2. The first and second boundaries BD1 and BD2 may extend in the first direction D1. The single height cell SHC may have a third boundary BD3 and a fourth boundary BD4 that are opposite to each other in the first direction D1. The third and fourth boundaries BD3 and BD4 may extend in the second direction D2.

The single height cell SHC may be provided on its opposite sides with a pair of separation structures DB that are opposite to each other in the second direction D2. For example, the pair of separation structures DB may be correspondingly provided on the first and second boundaries BD1 and BD2 of the single height cell SHC. The separation structure DB may extend lengthwise in the first direction D1 parallel to the first and second gate electrodes GE1 and GE2. A pitch between the separation structure DB and its adjacent first and second gate electrodes GE1 and GE2 may be the same as the first pitch.

The separation structures DB may penetrate the first and second interlayer dielectric layers 110 and 120 to extend into the first and second active patterns AP 1 and AP2. The separation structures DB may penetrate an upper portion of each of the first and second active patterns AP1 and AP2. For example, a lower surface of the separation structures DB may be at a lower level than upper surfaces of the first and second active patterns AP1 and AP2. The separation structures DB may electrically separate an active region of the single height cell SHC from an active region of an adjacent another cell.

Active contacts AC may be provided to penetrate the first and second interlayer dielectric layers 110 and 120 to come into electrical connection with the first and second source/drain patterns SD1 and SD2. A pair of active contacts AC may be provided on opposite sides of each of the first and second gate electrodes GE1 and GE2. When viewed in plan, the active contact AC may have a bar shape that extends lengthwise in the first direction D1.

The active contact AC may be a self-aligned contact. For example, the gate capping pattern GP and the gate spacer GS may be used to form the active contact AC in a self-alignment manner. The active contact AC may cover, for example, at least a portion of a sidewall of the gate spacer GS. Although not shown, the active contact AC may partially cover a top surface of the gate capping pattern GP.

A metal-semiconductor compound layer SC, or a silicide layer, may be interposed between the active contact AC and the first source/drain pattern SD1 and between the active contact AC and the second source/drain pattern SD2. The active contact AC may be electrically connected through the metal-semiconductor compound layer SC to one of the first and second source/drain patterns SD1 and SD2. For example, the metal-semiconductor compound layer SC may include at least one selected from titanium silicide, tantalum silicide, tungsten silicide, nickel silicide, and cobalt silicide.

Gate contacts GC may be provided to penetrate the second interlayer dielectric layer 120 and the gate capping pattern GP to correspondingly come into electrical connection with the first and second gate electrodes GE1 and GE2. When viewed in plan, the gate contacts GC may be disposed to correspondingly overlap the first active region AR1 and the second active region AR2. For example, the gate contact GC may be provided on the second active pattern AP2 (see FIG. 5B).

In an embodiment of the present inventive concepts, referring to FIG. 5B, the active contact AC may have an upper portion adjacent to the gate contact GC, and an upper dielectric pattern UIP may fill the upper portion of the active contact AC. The upper dielectric pattern UIP may have a bottom surface lower than that of the gate contact GC. For example, the upper dielectric pattern UIP may cause the active contact AC adjacent to the gate contact GC to have a top surface lower than the bottom surface of the gate contact GC. Therefore, it may be possible to prevent a short-circuit resulting from contact between the gate contact GC and its adjacent active contact AC.

Each of the active contact AC and the gate contact GC may include a conductive pattern FM and a barrier pattern BM that surrounds the conductive pattern FM. For example, the conductive pattern FM may include at least one metal selected from aluminum, copper, tungsten, molybdenum, and cobalt. The barrier pattern BM may cover sidewalls and a bottom surface of the conductive pattern FM. The barrier pattern BM may include a metal layer and a metal nitride layer. The metal layer may include at least one selected from titanium, tantalum, tungsten, nickel, cobalt, and platinum. The metal nitride layer may include at least one selected from a titanium nitride (TiN) layer, a tantalum nitride (TaN) layer, a tungsten nitride (WN) layer, a nickel nitride (NiN) layer, a cobalt nitride (CoN) layer, and a platinum nitride (PtN) layer.

A first metal layer M1 may be provided in the third interlayer dielectric layer 130. For example, the first metal layer M1 may include a first power line M1_R1, a second power line M1_R2, and first wiring lines M1_I. The lines M1_R1, M1_R2, and M1_I of the first metal layer M1 may extend lengthwise in parallel to each other in the second direction D2.

For example, the first and second power lines M1_R1 and M1_R2 may be respectively provided on the third and fourth boundaries BD3 and BD4 of the single height cell SHC. The first power line M1_R1 may extend lengthwise in the second direction D2 along the third boundary BD3. The second power line M1_R2 may extend lengthwise in the second direction D2 along the fourth boundary BD4.

The first wiring lines M1_I of the first metal layer M1 may be disposed between the first and second power lines M1_R1 and M1_R2. The first wiring lines M1_I of the first metal layer M1 may be arranged at a second pitch along the first direction D1. The second pitch may be less than the first pitch. Each of the first wiring lines M1_I may have a line-width less than that of each of the first and second power lines M1_R1 and M1_R2.

The first metal layer M1 may further include first vias VI1. The first vias VI1 may be correspondingly provided below the lines M1_R1, M1_R2, and M1_I of the first metal layer M1. The first via VI1 may electrically connect the active contact AC to a certain line of the first metal layer M1. For example, the first via VI1 may contact an upper surface of the active contact AC and a lower surface of a first wiring line M1_I of the first metal layer M1. The first via VI1 may electrically connect the gate contact GC to a wiring line of the first metal layer M1. For example, the first via VI1 may contact an upper surface of the gate contact GC and a lower surface of a first wiring line M1_I of the first metal layer M1.

A certain first wiring line M1_I and its underlying first via VI1 of the first metal layer M1 may be formed by individual processes. For example, the certain first wiring line M1_I and its underlying first via VI1 of the first metal layer M1 may each be formed by a single damascene process. A sub-20 nm process may be employed to fabricate a semiconductor device according to the present embodiment.

A second metal layer M2 may be provided in the fourth interlayer dielectric layer 140. The second metal layer M2 may include a plurality of second wiring lines M2_I. The second wiring lines M2_I of the second metal layer M2 may each have a linear or bar shape that extends lengthwise in the first direction D1. For example, the second wiring lines M2_I may parallel extend in the first direction D1.

The second metal layer M2 may further include second vias VI2 that are correspondingly provided below the second wiring lines M2_I. A certain line of the first metal layer M1 may be electrically connected through the second via VI2 to a corresponding line of the second metal layer M2. For example, the second via VI2 may contact an upper surface of a first wiring line M1_I of the first metal layer M1 and a lower surface of a second wiring line M2_I of the second metal layer M2. For example, a certain line and its underlying second via VI2 of the second metal layer M2 may be simultaneously formed in a dual damascene process.

The first and second metal layers M1 and M2 may have their wiring lines that include the same or different conductive materials. For example, the wiring lines of the first and second metal layers M1 and M2 may include at least one metallic material selected from aluminum, copper, tungsten, molybdenum, ruthenium, and cobalt. Although not shown, other metal layers (e.g., M3, M4, M5, etc.) may be additionally stacked on the fourth interlayer dielectric layer 140. Each of the stacked metal layers may include wiring lines for routing between cells.

In a semiconductor device, a thickness of a first inner gate spacer interposed between an inner gate electrode and a first source/drain pattern including impurities of a first conductivity type (e.g., n-type) may be substantially the same as a size of a second inner gate spacer interposed between an inner gate electrode and a second source/drain pattern including impurities of a second conductivity type (e.g., p-type). For example, the second inner gate spacer may have a relatively large thickness, and the second source/drain pattern may have a decreased size, which may result in a reduction in compressive stress provided to a channel pattern. As a result, there may be a limitation of improvement in mobility of carriers that move through the channel pattern between the second source/drain patterns.

In contrast, in a semiconductor device according to some embodiments of the present inventive concepts, a thickness of a first inner gate spacer (e.g., first inner gate spacer IGS 1) interposed between an inner gate electrode and a first source/drain pattern including, for example, impurities of a first conductivity type (e.g., n-type) may be greater than a size of a second inner gate spacer (e.g., second inner gate spacer IGS2) interposed between an inner gate electrode and a second source/drain pattern including, for example, impurities of a second conductivity type (e.g., p-type). As the first inner gate spacer (e.g., first inner gate spacer IGS1) has a larger thickness, an externally leaked current may be reduced to prevent the occurrence of parasitic capacitance. As the second inner gate spacer (e.g., second inner gate spacer IGS2) has a smaller thickness, a compressive stress provided from the second source/drain pattern may be increased to improve carrier mobility. As a result, a semiconductor device may have improved electrical characteristics and increased reliability.

In addition, according to some embodiments of the present inventive concepts, an amount of silicon nitride included in the first inner gate spacer (e.g., first inner gate spacer IGS 1) may be greater than an amount of silicon nitride included in the second inner gate spacer (e.g., second inner gate spacer IGS2) (see FIGS. 7A and 7B). In this case, as the silicon nitride has positive surface charges, there may be an improvement in performance of the channel pattern interposed between the first source/drain patterns including, for example, impurities of the first conductivity type (e.g., n-type). Moreover, it may be possible to decrease a reduction in performance, i.e., improve performance, of the channel pattern interposed between the second source/drain patterns including, for example, the second impurities of the second conductivity type (e.g., p-type).

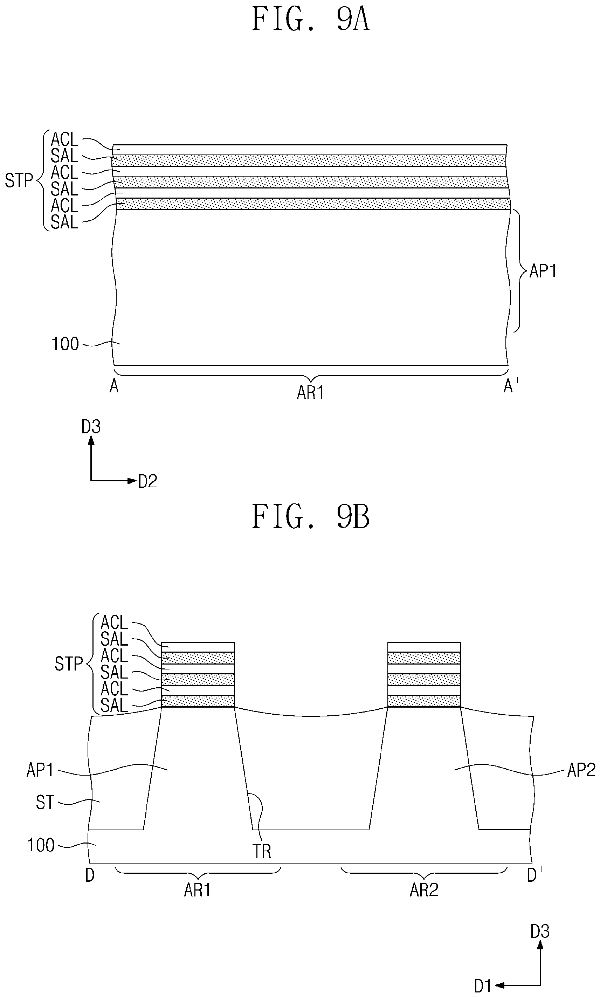

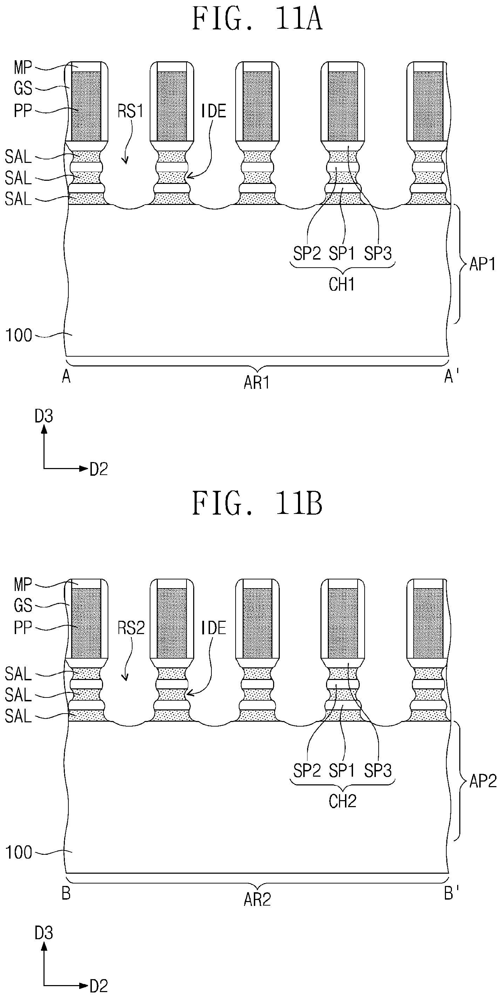

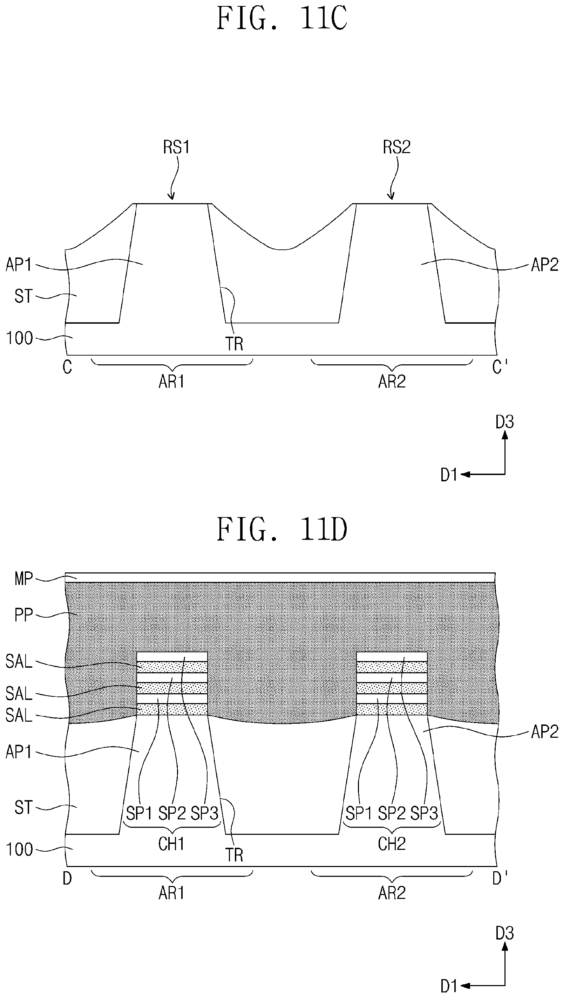

FIGS. 9A to 14C illustrate cross-sectional views showing a method of fabricating a semiconductor device according to some example embodiments of the present inventive concepts. In detail, FIGS. 9A, 10A, 11A, 12A, 13A, and 14A illustrate cross-sectional views taken along line A-A' of FIG. 4. FIGS. 11B, 12B, and 13B illustrate cross-sectional views taken along line B-B' of FIG. 4. FIGS. 11C, 12C, 13C, and 14B illustrate cross-sectional views taken along line C-C' of FIG. 4. FIGS. 9B, 10B, 11D, 12D, 13D, and 14C illustrate cross-sectional views taken along line D-D' of FIG. 4.

Referring to FIGS. 9A and 9B, a substrate 100 may be provided which includes a first active region AR1 and a second active region AR2. Active layers ACL and sacrificial layers SAL may be alternately formed on the substrate 100. The active layers ACL may include one of silicon (Si), germanium (Ge), and silicon-germanium (SiGe), and the sacrificial layers SAL may include another of silicon (Si), germanium (Ge), and silicon-germanium (SiGe).

The sacrificial layer SAL may include a material having an etch selectivity with respect to the active layer ACL. For example, the active layers ACL may include silicon (Si), and the sacrificial layers SAL may include silicon-germanium (SiGe). Each of the sacrificial layers SAL may have a germanium concentration of about 10 at% to about 30 at%.

Mask patterns may be formed on the first and second active regions AR1 and AR2 of the substrate 100. The mask pattern may have a linear or bar shape that extends lengthwise in a second direction D2.

A patterning process may be performed in which the mask patterns are used as an etching mask to form trenches TR that define a first active pattern AP1 and a second active pattern AP2. The first active pattern AP1 may be formed on the first active region AR1. The second active pattern AP2 may be formed on the second active region AR2.

A stack pattern STP may be formed on each of the first and second active patterns AP1 and AP2. The stack pattern STP may include the active layers ACL and the sacrificial layers SAL that are alternately stacked. During the patterning process, the stack pattern STP may be formed together with the first and second active patterns AP1 and AP2.

A device isolation layer ST may be formed to fill the trenches TR. For example, a dielectric layer may be formed on a front surface of the substrate 100 to cover the stack patterns STP and the first and second active patterns AP1 and AP2. The dielectric layer may be recessed until the stack patterns STP are exposed, and thus the device isolation layer ST may be formed.

The device isolation layer ST may include a dielectric material, such as a silicon oxide layer. The stack patterns STP may be exposed upwardly from the device isolation layer ST. For example, the stack patterns STP may vertically protrude upwards from the device isolation layer ST.

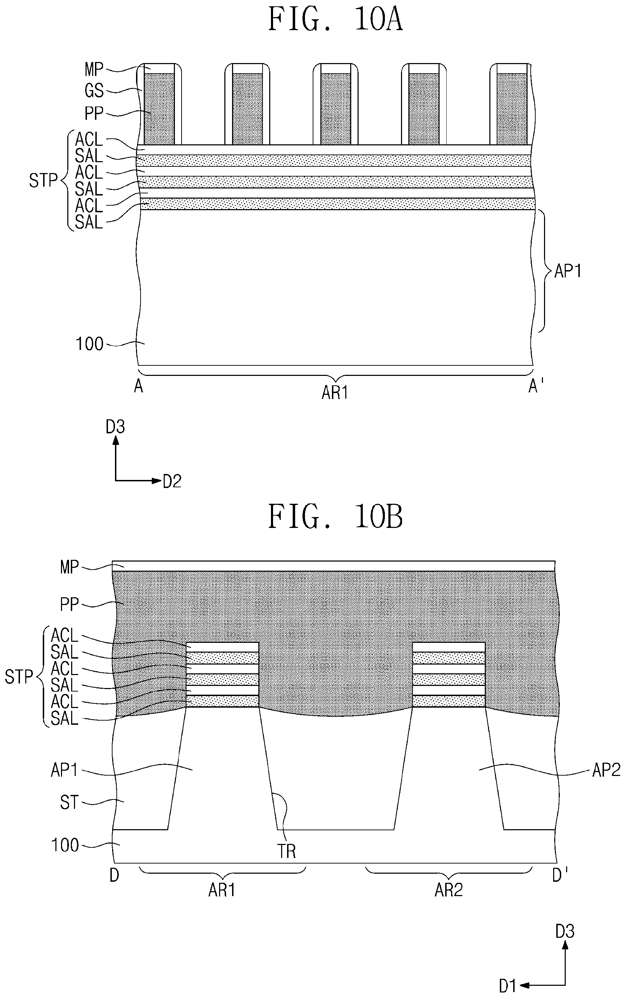

Referring to FIGS. 10A and 10B, sacrificial patterns PP may be formed on the substrate 100 to run across the stack patterns STP. Each of the sacrificial patterns PP may be formed to have a linear or bar shape that extends lengthwise in a first direction D1. The sacrificial patterns PP may be arranged at a first pitch along the second direction D2.

For example, the formation of the sacrificial patterns PP may include forming a sacrificial layer on the front surface of the substrate 100, forming hardmask patterns MP on the sacrificial layer, and using the hardmask patterns MP as an etching mask to pattern the sacrificial layer. The sacrificial layer may include polysilicon.

A pair of gate spacers GS may be formed on opposite sidewalls of each of the sacrificial patterns PP. The formation of the gate spacers GS may include conformally forming a gate spacer layer on the front surface of the substrate 100 and anisotropically etching the gate spacer layer. In an embodiment of the present inventive concepts, the gate spacer GS may be a multiple layer including at least two layers.

Referring to FIGS. 11A to 11D, first recesses RS1 may be formed in the stack pattern STP on the first active pattern AP 1. Second recesses RS2 may be formed in the stack pattern STP on the second active pattern AP2. During the formation of the first and second recesses RS1 and RS2, the device isolation layer ST may further be recessed on opposite sides of each of the first and second active patterns AP1 and AP2 (see FIG. 11C).

For example, the hardmask patterns MP and the gate spacers GS may be used as an etching mask such that the stack pattern STP on the first active pattern AP1 may be etched to form the first recesses RS1. The first recess RS1 may be formed between a pair of sacrificial patterns PP.

In an embodiment of the present inventive concepts, a selective etching process may further be performed on the sacrificial layers SAL exposed by the second recess RS2. In the selective etching process, each of the sacrificial layers SAL may be indented to form an indent region IDE. Indent regions IDE may be formed on the second active pattern AP2. The indent regions IDE may cause the second recess RS2 to have a wavy inner sidewall.

The active layers ACL may be formed into first, second, and third semiconductor patterns SP1, SP2, and SP3 that are sequentially stacked between neighboring first recesses RS 1. A first channel pattern CH1 may be constituted by the first, second, and third semiconductor patterns SP1, SP2, and SP3 between neighboring first recesses RS 1.

The active layers ACL may be formed into first, second, and third semiconductor patterns SP1, SP2, and SP3 that are sequentially stacked between neighboring second recesses RS2. A second channel pattern CH2 may be constituted by the first, second, and third semiconductor patterns SP1, SP2, and SP3 between neighboring second recesses RS2.

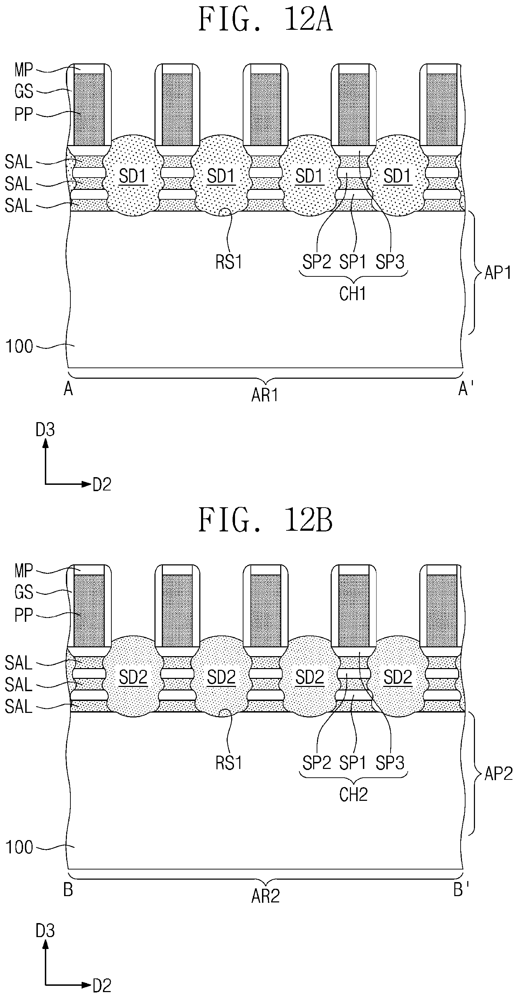

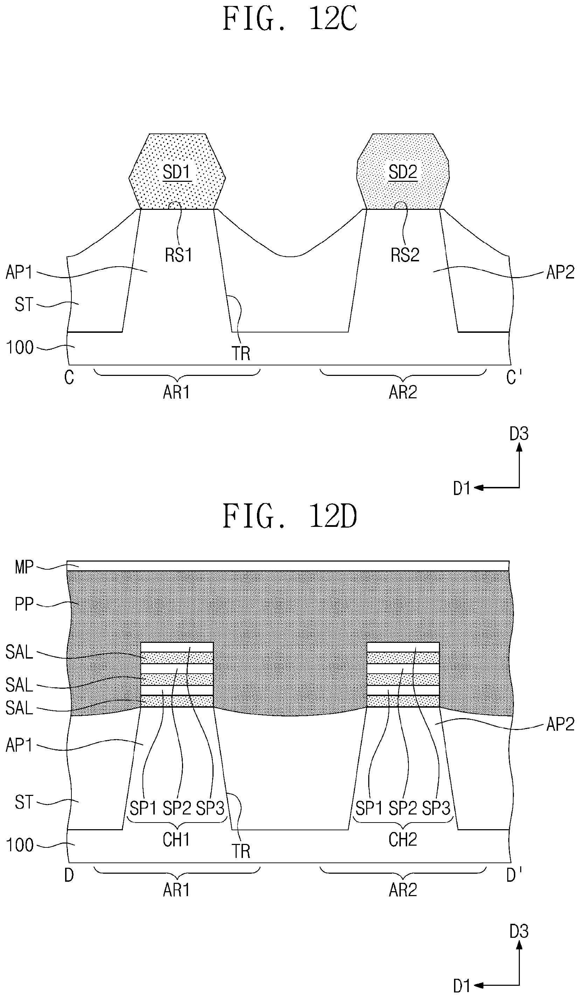

Referring to FIGS. 12A to 12D, first source/drain patterns SD1 may be correspondingly formed in the first recesses RS 1. For example, a selective epitaxial growth (SEG) process may be performed in which an inner sidewall of the first recess RS1 is used as a seed layer to form an epitaxial layer that fills the first recess RS 1. The epitaxial layer may be grown from a seed or the substrate 100 and the first, second, and third semiconductor patterns SP1, SP1, and SP3 exposed by the first recess RS 1. For example, the SEG process may include chemical vapor deposition (CVD) or molecular beam epitaxy (MBE).

In an embodiment of the present inventive concepts, the first source/drain pattern SD1 may include the same semiconductor element (e.g., Si) as that of the substrate 100. During the formation of the first source/drain pattern SD1, impurities (e.g., phosphorus, arsenic, or antimony) may be in-situ implanted to allow the first source/drain pattern SD1 to have, for example, an n-type conductivity. Alternatively, after the formation of the first source/drain pattern SD1, impurities may be implanted into the first source/drain pattern SD1.

Second source/drain patterns SD2 may be correspondingly formed in the second recesses RS2. For example, a selective epitaxial growth (SEG) process may be performed such that the inner sidewall of the second recess RS2 is used as a seed to form the second source/drain pattern SD2.

In an embodiment of the present inventive concepts, the second source/drain pattern SD2 may include a semiconductor element (e.g., SiGe) whose lattice constant is greater than that of a semiconductor element of the substrate 100. During the formation of the second source/drain pattern SD2, impurities (e.g., boron, gallium, or indium) may be in-situ implanted to allow the second source/drain pattern SD2 to have, for example, a p-type conductivity. Alternatively, after the formation of the second source/drain pattern SD2, impurities may be implanted into the second source/drain pattern SD2.

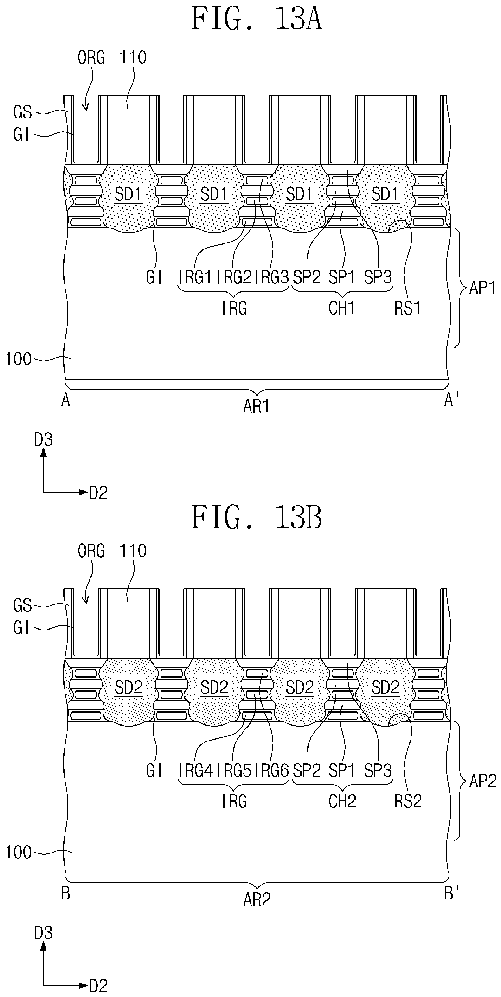

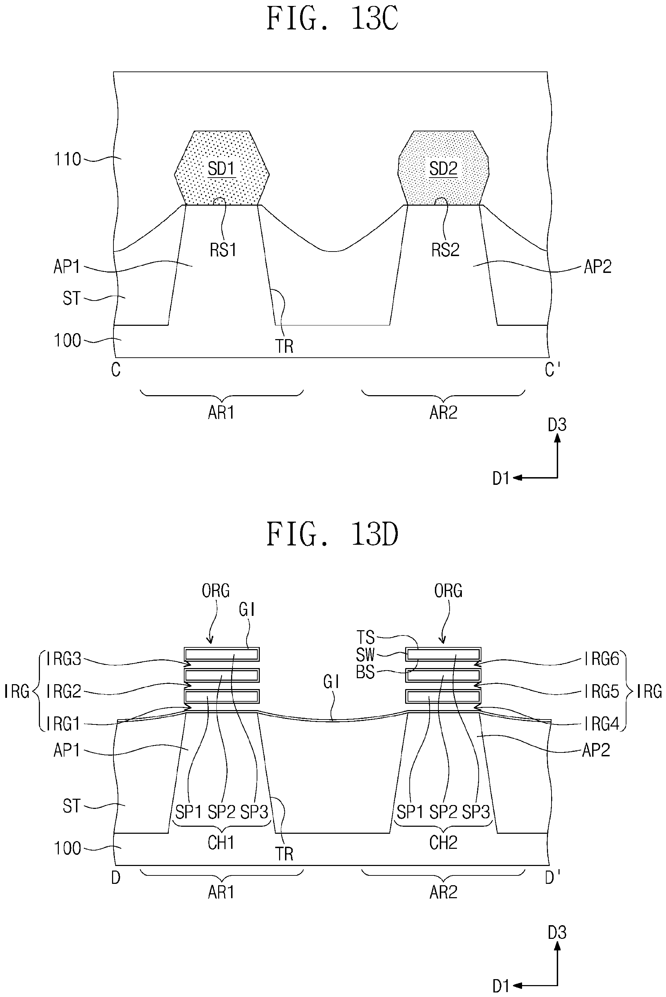

Referring to FIGS. 13A to 13D, a first interlayer dielectric layer 110 may be formed to cover the first and second source/drain patterns SD1 and SD2, the hardmask patterns MP, and the gate spacers GS. For example, the first interlayer dielectric layer 110 may include a silicon oxide layer.

The first interlayer dielectric layer 110 may be planarized until top surfaces of the sacrificial patterns PP are exposed. An etch-back or chemical mechanical polishing (CMP) process may be used to planarize the first interlayer dielectric layer 110. The hardmask patterns MP may all be removed during the planarization process. As a result, the first interlayer dielectric layer 110 may have a top surface coplanar with those of the sacrificial patterns PP and those of the gate spacers GS.

The exposed sacrificial patterns PP may be selectively removed. The removal of the sacrificial patterns PP may form an outer region ORG that exposes the first and second channel patterns CH1 and CH2 (see FIG. 13D). The removal of the sacrificial patterns PP may include performing a wet etching process using an etchant that selectively etches polysilicon.

The sacrificial layers SAL exposed through the outer region ORG may be selectively removed to form inner regions IRG (see FIG. 13D). For example, an etching process that selectively etches the sacrificial layers SAL may be performed such that only the sacrificial layers SAL may be removed while leaving the first, second, and third semiconductor patterns SP1, SP2, and SP3. The etching process may have a high etch rate for silicon-germanium having a relatively high germanium concentration. For example, the etching process may have a high etch rate for silicon-germanium whose germanium concentration is greater than about 10 at%.

The etching process may remove the sacrificial layers SAL on the first and second active regions AR1 and AR2. The etching process may be a wet etching process. An etching material used for the etching process may promptly etch the sacrificial layer SAL whose germanium concentrate is relatively high.

As the sacrificial layers SAL are selectively removed, only the first, second, and third semiconductor patterns SP1, SP2, and SP3 may remain on each of the first and second active patterns AP1 and AP2. Spaces from which the sacrificial layers SAL are removed may be formed into first, second, and third inner regions IRG1, IRG2, and IRG3 on the first active pattern AP1, and into fourth, fifth, and sixth inner regions IRG4, IRG5, and IRG6 on the second active pattern AP2.

For example, on the first active pattern AP1, the first inner region IRG1 may be formed between the first active pattern AP1 and the first semiconductor pattern SP1, the second inner region IRG2 may be formed between the first semiconductor pattern SP1 and the second semiconductor pattern SP2, and the third inner region IRG3 may be formed between the second semiconductor pattern SP2 and the third semiconductor pattern SP3. On the second active pattern AP2, the fourth inner region IRG4 may be formed between the second active pattern AP2 and the first semiconductor pattern SP1, the fifth inner region IRG5 may be formed between the first semiconductor pattern SP1 and the second semiconductor pattern SP2, and the sixth inner region IRG6 may be formed between the second semiconductor pattern SP2 and the third semiconductor pattern SP3.

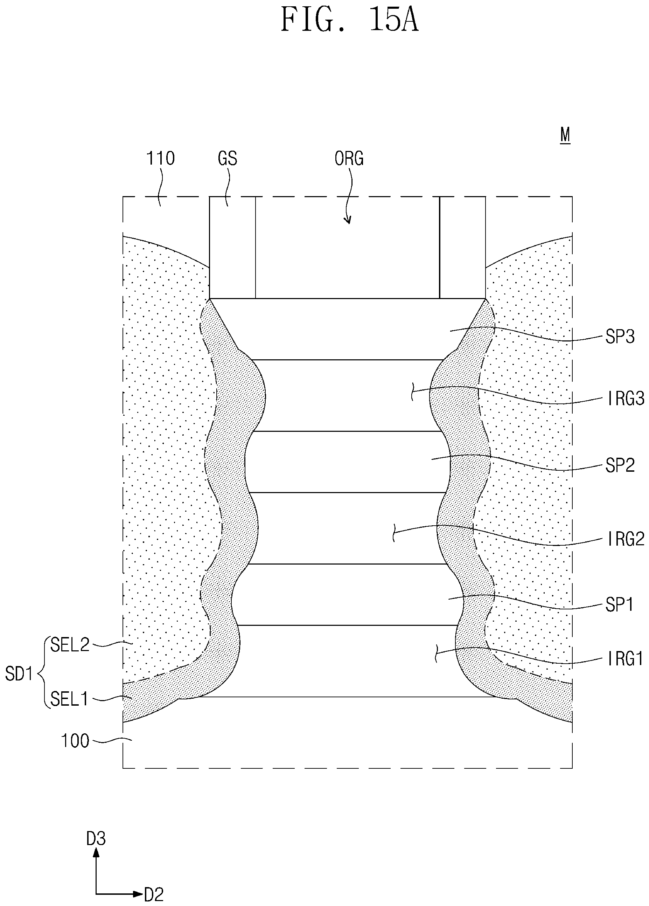

Referring back to FIGS. 13A to 13D, a gate dielectric layer GI may be formed on the exposed first, second, and third semiconductor patterns SP1, SP2, and SP3. The gate dielectric layer GI may be formed to surround each of the first, second, and third semiconductor patterns SP1, SP2, and SP3. The gate dielectric layer GI may be formed in each of the first, second, and third inner regions IRG1, IRG2, and IRG3. The gate dielectric layer GI may also be formed in the outer region ORG. The following will describe in detail the formation of the gate dielectric layer GI with reference to FIGS. 15A to 20B.

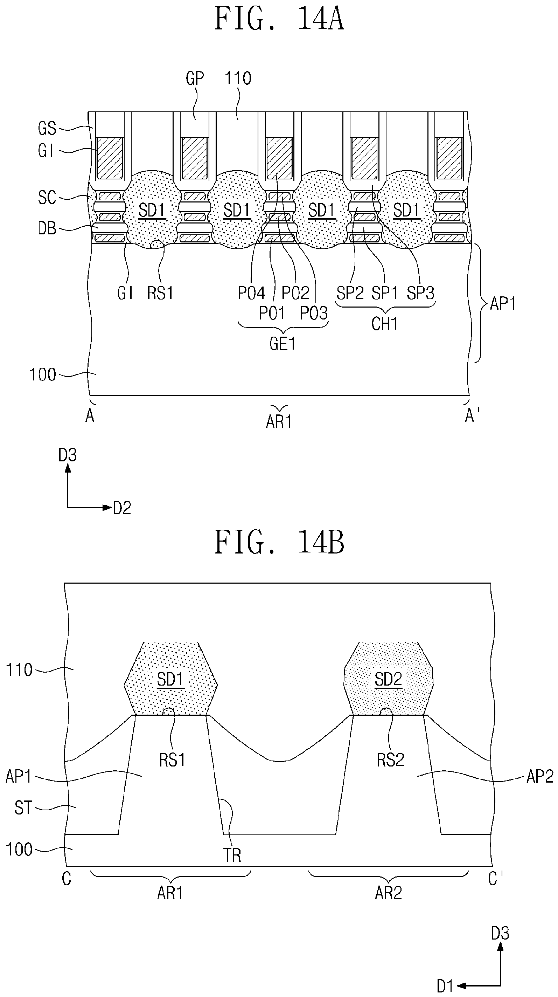

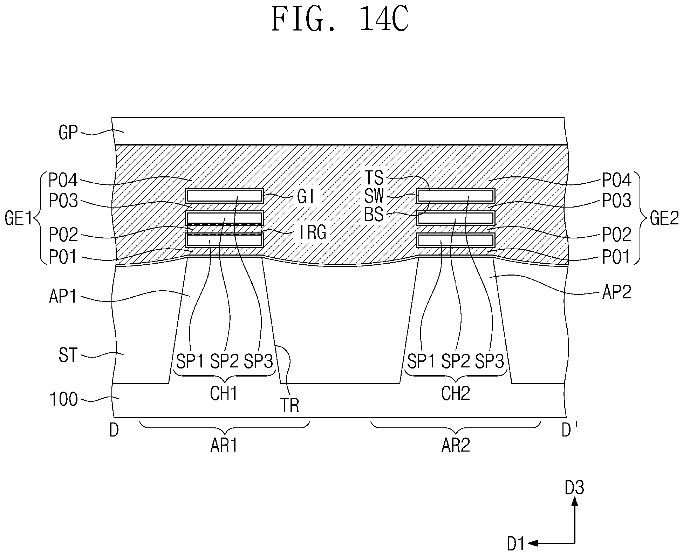

Referring to FIGS. 14A to 14C, first and second gate electrodes GE1 and GE2 may be formed on the gate dielectric layer GI. The first and second gate electrodes GE1 and GE2 may be formed on a high-k dielectric layer (see, e.g., high-k dielectric layer HK of FIG. 6A). For example, a high-k dielectric layer may be formed on the gate dielectric layer GI, and the first and second gate electrodes GE1 and GE2 may be formed on the high-k dielectric layer. The first gate electrode GE1 may include first, second, and third inner gate electrodes PO1, PO2, and PO3 that are respectively formed in the first, second, and third inner regions IRG1, IRG2, and IRG3, and may also include an outer gate electrode PO4 formed in the outer region ORG. The second gate electrode GE2 may include first, second, and third inner gate electrodes PO1, PO2, and PO3 that are respectively formed in the fourth, fifth, and sixth inner regions IRG4, IRG5, and IRG6, and may also include an outer gate electrode PO4 formed in the outer region ORG. The first and second gate electrodes GE1 and GE2 may be recessed to have a reduced height. A gate capping pattern GP may be formed on each of the reduced first and second gate electrodes GE1 and GE2.

Referring back to FIGS. 5A to 5D, a second interlayer dielectric layer 120 may be formed on the first interlayer dielectric layer 110. The second interlayer dielectric layer 120 may include a silicon oxide layer. Active contacts AC may be formed to penetrate the second and first interlayer dielectric layers 120 and 110 to come into electrical connection with the first and second source/drain patterns SD1 and SD2. A gate contact GC may be formed to penetrate the second interlayer dielectric layer 120 and the gate capping pattern GP to come into electrical connection with the gate electrode GE1 or GE2.

The formation of each of the active contact AC and the gate contact GC may include forming a barrier pattern BM and forming a conductive pattern FM on the barrier pattern BM. The barrier pattern BM may be conformally formed to include a metal layer and a metal nitride layer. The conductive pattern FM may include metal having a low resistance.

Separation structures DB may be correspondingly formed on first and second boundaries BD1 and BD2 of the single height cell SHC. The separation structure DB may extend from the second interlayer dielectric layer 120 through the gate electrode GE1 or GE2 into the active pattern AP1 or AP2. The separation structure DB may include a dielectric material, such as a silicon oxide layer or a silicon nitride layer.

A third interlayer dielectric layer 130 may be formed on the active contacts AC and the gate contacts GC. A first metal layer M1 may be formed in the third interlayer dielectric layer 130. A fourth interlayer dielectric layer 140 may be formed on the third interlayer dielectric layer 130. A second metal layer M2 may be formed in the fourth interlayer dielectric layer 140.

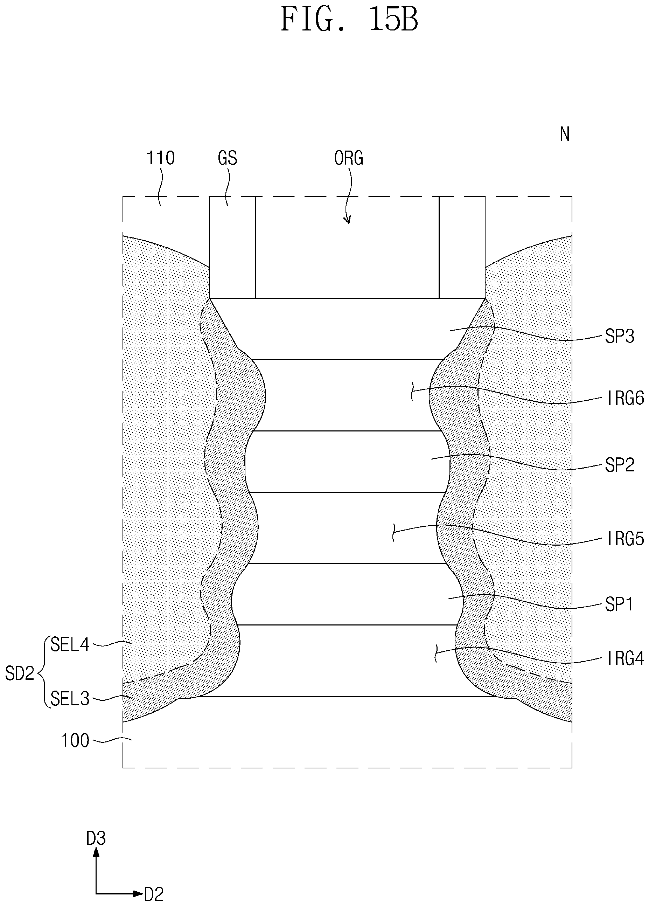

FIGS. 15A to 17B illustrate diagrams showing a method of forming a gate dielectric layer of a semiconductor device according to some example embodiments of the present inventive concepts. In detail, FIGS. 15A, 16A, and 17A illustrate enlarged views showing a method of forming section M depicted in FIG. 6A. FIGS. 15B, 16B, and 17B illustrate enlarged views showing a method of forming section N depicted in FIG. 6B.

Referring to FIGS. 15A and 15B, as discussed above, a selective etching process may be performed on the sacrificial layers SAL. For example, an etching process that selectively etches the sacrificial layers SAL may be performed such that only the sacrificial layers SAL may be removed while leaving the first, second, and third semiconductor patterns SP1, SP2, and SP3 (see FIGS. 13A and 13B). As a result of the etching process, spaces from which the sacrificial layers SAL are removed may be formed into first, second, and third inner regions IRG1, IRG2, and IRG3 on the first active pattern AP1, and into fourth, fifth, and sixth inner regions IRG4, IRG5, and IRG6 on the second active pattern AP2.

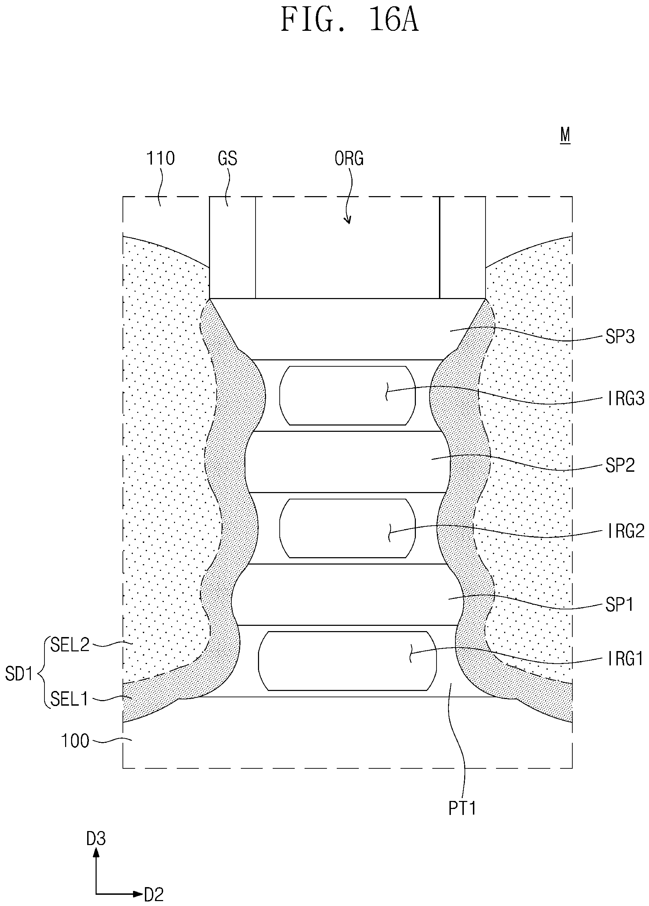

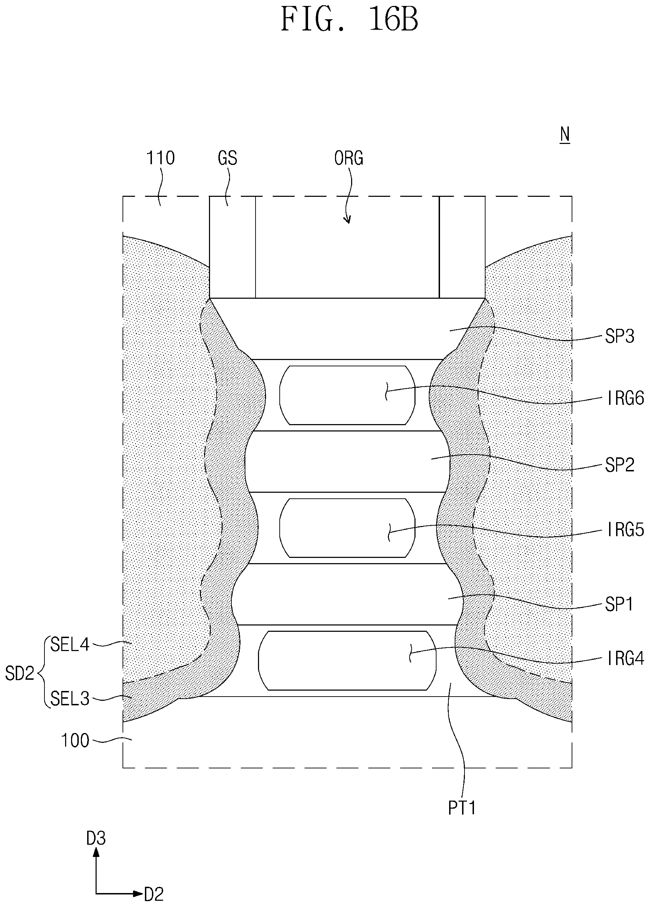

Referring to FIGS. 16A and 16B, a first dielectric pattern PT1 may be conformally formed in the first, second, and third inner regions IRG1, IRG2, and IRG3 and in the fourth, fifth, and sixth inner regions IRG4, IRG5, and IRG6. The first dielectric pattern PT1 may be formed to partially, rather than completely, fill the first, second, and third inner regions IRG1, IRG2, and IRG3 and the fourth, fifth, and sixth inner regions IRG4, IRG5, and IRG6. The first dielectric pattern PT1 may be formed by performing physical vapor deposition (PVD), chemical vapor deposition (CVD), or atomic layer deposition (ALD).

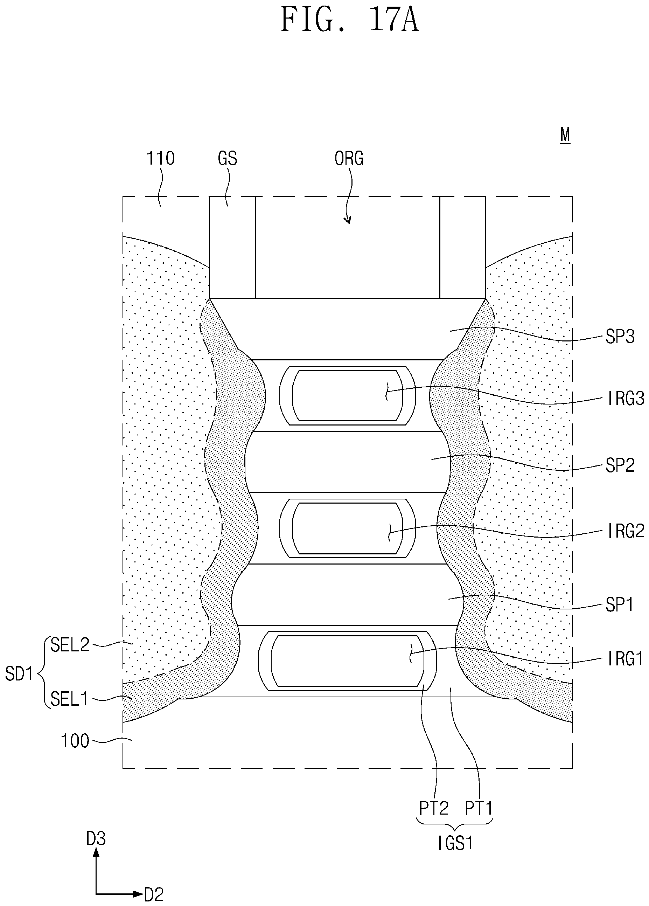

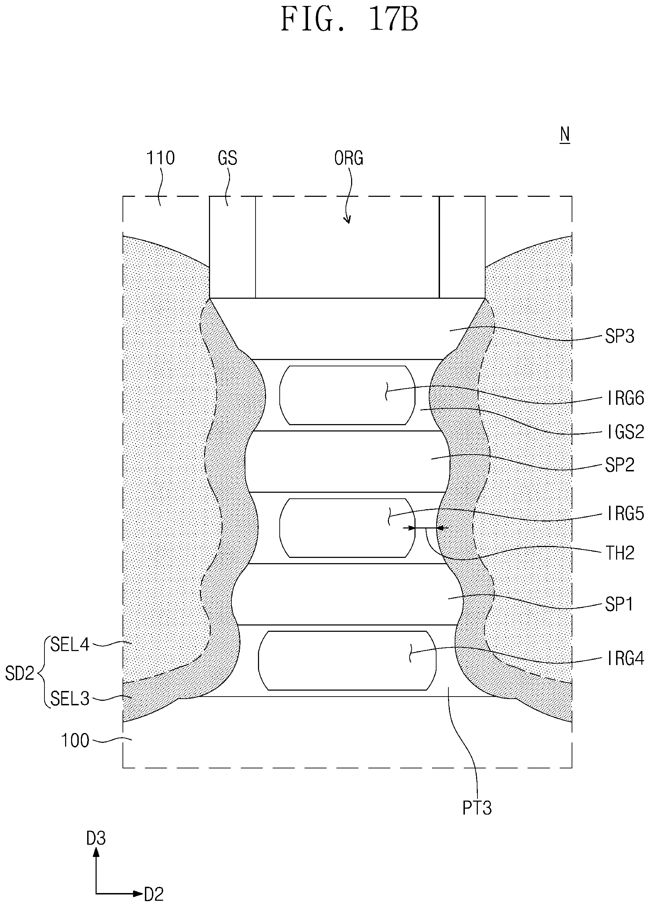

Referring to FIGS. 17A and 17B, although not shown, the first dielectric pattern PT1 may be removed from the fourth, fifth, and sixth inner regions IRG4, IRG5, and IRG6. The removal of the first dielectric pattern PT1 may include forming a mask pattern that selectively exposes the fourth, fifth, and sixth inner regions IRG4, IRG5, and IRG6, using the mask pattern as an etching mask to remove the first dielectric pattern PT1 in the fourth, fifth, and sixth inner regions IRG4, IRG5, and IRG6, and performing a cleaning process to remove residues of the first dielectric pattern PT1. The cleaning process may use, for example, a hydrogen fluoride (HF) solution.

Afterwards, a second dielectric pattern PT2 may be conformally formed in internal spaces the first, second, and third inner regions IRG1, IRG2, and IRG3 in each of which the first dielectric pattern PT1 is formed, and a third dielectric pattern PT3 may be conformally formed in internal spaces of the fourth, fifth, and sixth inner regions IRG4, IRG5, and IRG6.

On the first dielectric pattern PT1 formed in the step of FIG. 16A, the second dielectric pattern PT2 may be formed to partially, rather than completely, fill the first, second, and third inner regions IRG1, IRG2, and IRG3. The third dielectric pattern PT3 may be formed to partially, rather than completely, fill the fourth, fifth, and sixth inner regions IRG4, IRG5, and IRG6. The second dielectric pattern PT2 and the third dielectric pattern PT3 may be formed by performing physical vapor deposition (PVD), chemical vapor deposition (CVD), or atomic layer deposition (ALD).

The first dielectric pattern PT1 and the second dielectric pattern PT2 may be formed in the first, second, and third inner regions IRG1, IRG2, and IRG3, thereby forming a first inner gate spacer IGS1. The third dielectric pattern PT3 may be formed in the fourth, fifth, and sixth inner regions IRG4, IRG5, and IRG6, thereby forming a second inner gate spacer IGS2. A sum of thicknesses in the second direction D2 of the first dielectric pattern PT1 and the second dielectric pattern PT2 in the first, second, and third inner regions IRG1, IRG2, and IRG3 may be substantially the same as the first thickness TH1 discussed in FIG. 6A. A thickness in the second direction D2 of the third dielectric pattern PT3 in the fourth, fifth, and sixth inner regions IRG4, IRG5, and IRG6 may be substantially the same as the second thickness TH2 discussed in FIG. 6B.

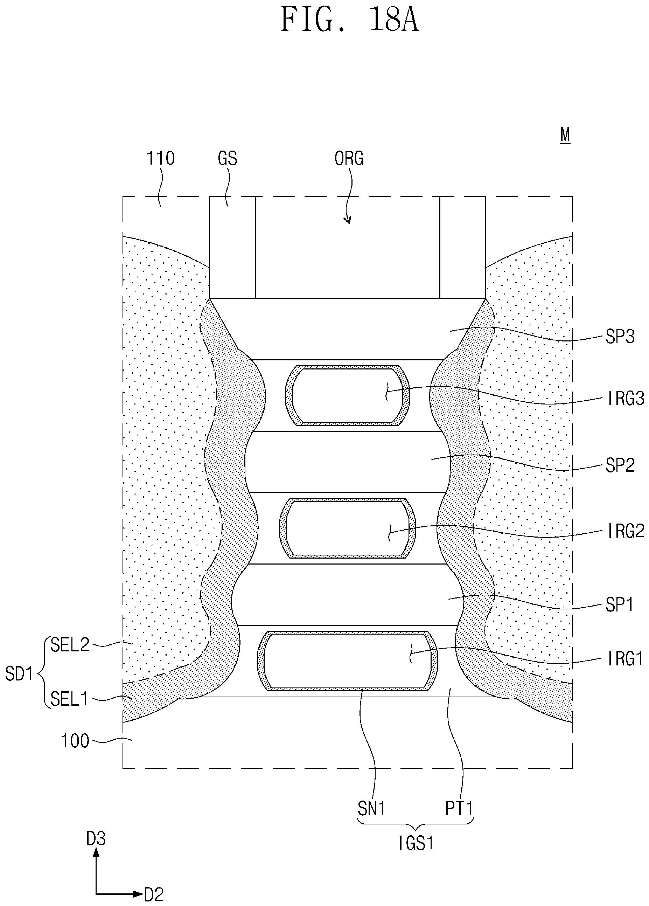

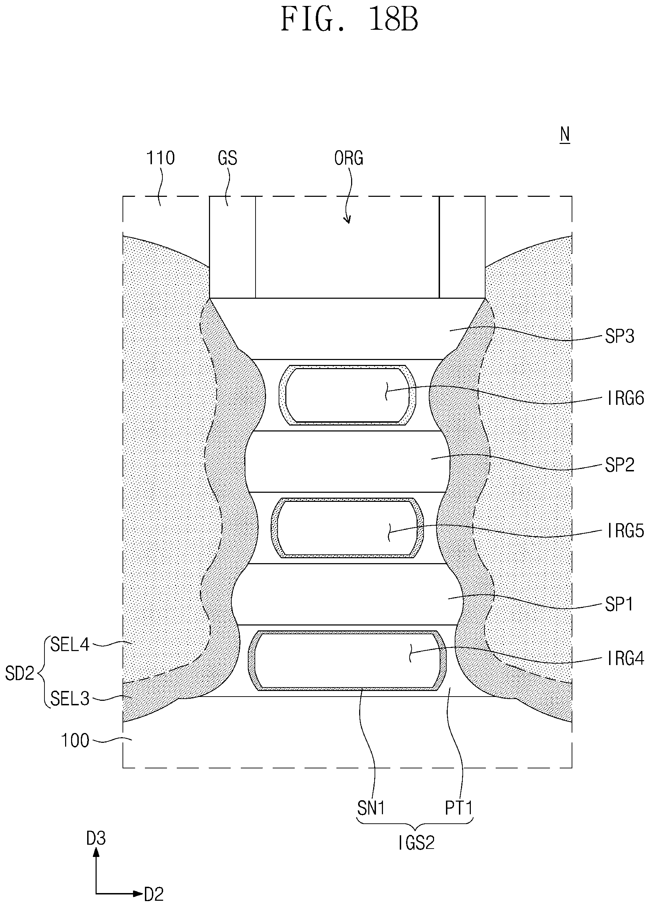

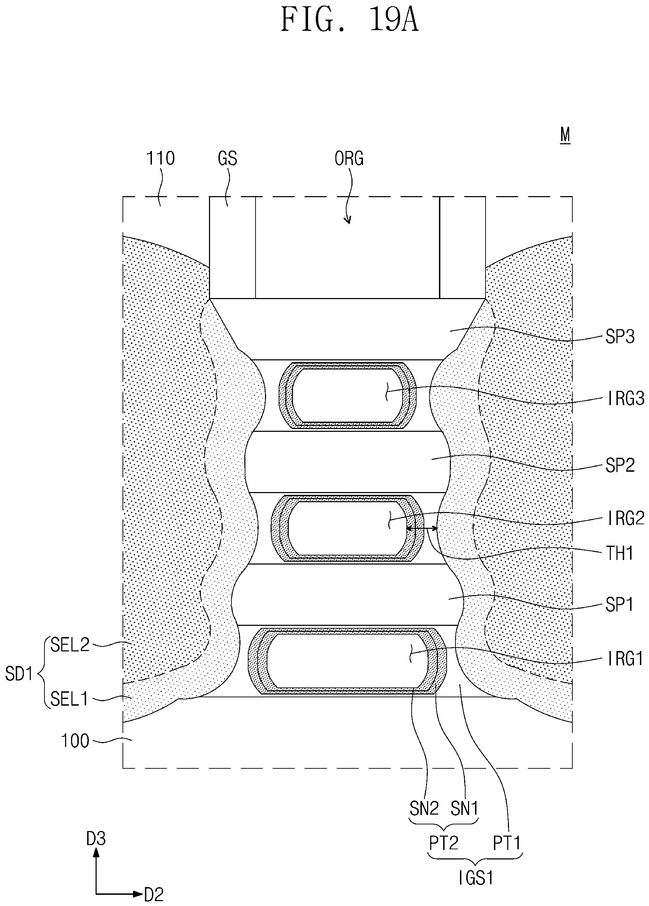

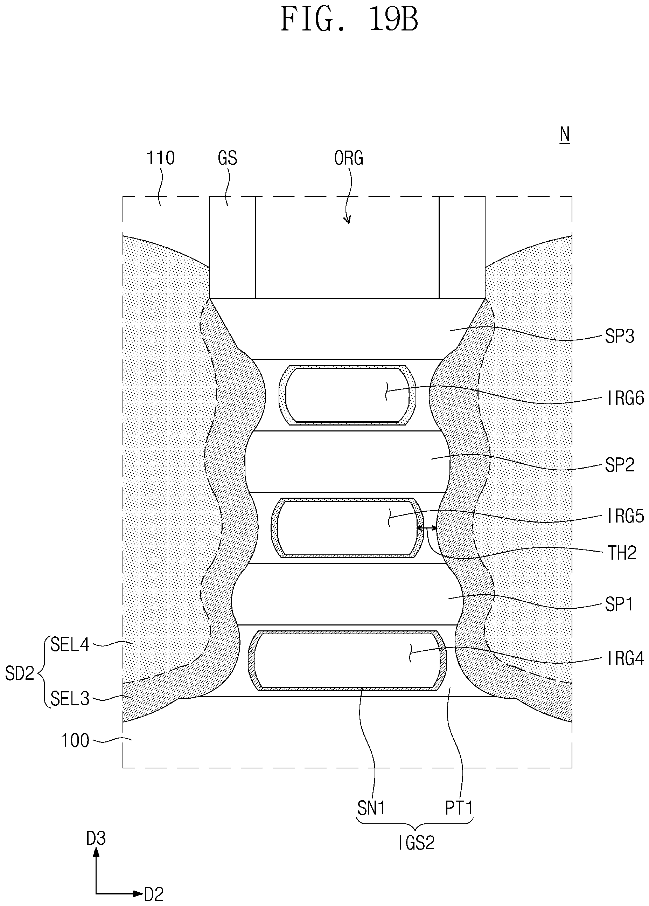

FIGS. 18A to 19B illustrate diagrams showing a method of forming a gate dielectric layer of a semiconductor device according to some example embodiments of the present inventive concepts. In detail, FIGS. 18A and 19A illustrate enlarged views showing a method of forming section M depicted in FIG. 7A. FIGS. 18B and 19B illustrate enlarged views showing a method of forming section N depicted in FIG. 7B.

Referring to FIGS. 15A, 15B, 18A, and 18B, a first dielectric pattern PT1 and a first protective pattern SN1 on the first dielectric pattern PT1 may be conformally formed in the first, second, and third inner regions IRG1, IRG2, and IRG3 and in the fourth, fifth, and sixth inner regions IRG4, IRG5, and IRG6. For example, the first dielectric pattern PT1 may be formed to partially, rather than completely, fill the first, second, and third inner regions IRG1, IRG2, and IRG3 and the fourth, fifth, and sixth inner regions IRG4, IRG5, and IRG6. The first dielectric pattern PT1 may be in contact with the first source/drain pattern SD1 or the second source/drain pattern SD2. Afterwards, the first protective pattern SN1 may be formed in internal spaces of the first, second, third, fourth, fifth, and sixth inner regions IRG1, IRG2, IRG3, IRG4, IRG5, and IRG6 in each of which the first dielectric pattern PT1 is formed. The first dielectric pattern PT1 and the first protective pattern SN1 may be formed by performing physical vapor deposition (PVD), chemical vapor deposition (CVD), or atomic layer deposition (ALD). For example, the first protective pattern SN1 may be formed by an atomic layer deposition, and this process may be performed seven or eight times.

Referring to FIGS. 19A and 19B, a second protective pattern SN2 may be formed in the internal spaces of the first, second, and third inner regions IRG1, IRG2, and IRG3 in each of which the first dielectric pattern PT1 and the first protective pattern SN1 are formed. The formation of the second protective pattern SN2 may include forming a mask pattern that selectively exposes the first, second, and third inner regions IRG1, IRG2, and IRG3; forming the second protective pattern SN2 in internal spaces of the exposed first, second, and third inner regions IRG1, IRG2, and IRG3 in each of which the first dielectric pattern PT1 and the first protective pattern SN1 are formed; removing the mask pattern; and then performing a cleaning process. The second protective pattern SN2 may be formed by performing physical vapor deposition (PVD), chemical vapor deposition (CVD), or atomic layer deposition (ALD).

As the second protective pattern SN2 is formed on the first protective pattern SN1, a second dielectric pattern PT2 may be formed to include the first protective pattern SN1 and the second protective pattern SN2.

A sum of thicknesses in the second direction D2 of the first dielectric pattern PT1 and the second dielectric pattern PT2 in the first, second, and third inner regions IRG1, IRG2, and IRG3 may be substantially the same as the first thickness TH1 discussed in FIG. 7A. A sum of thicknesses in the second direction D2 of the first dielectric pattern PT1 and the first protective pattern SN1 in the fourth, fifth, and sixth inner regions IRG4, IRG5, and IRG6 may be substantially the same as the second thickness TH2 discussed in FIG. 7B.

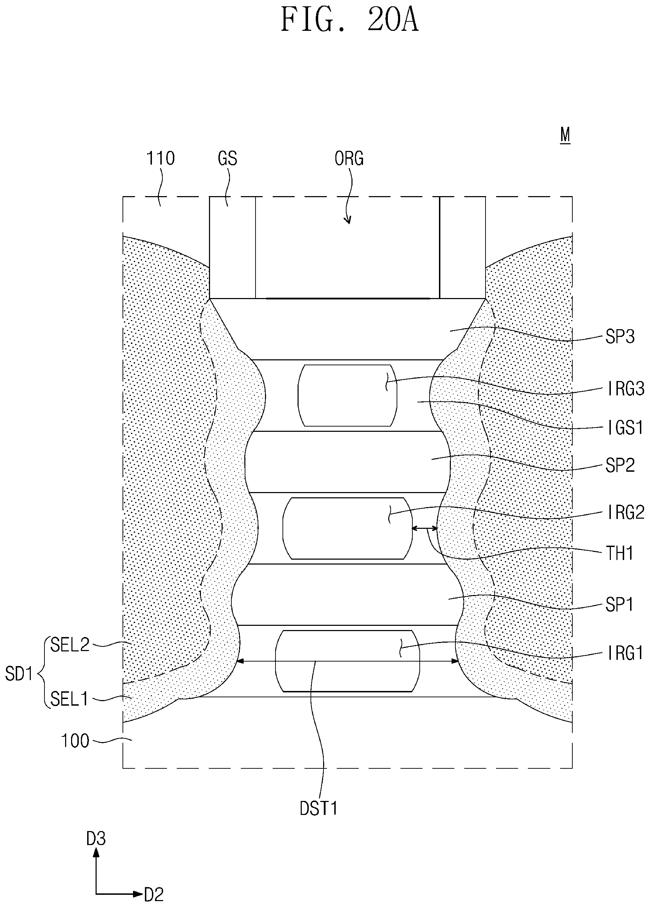

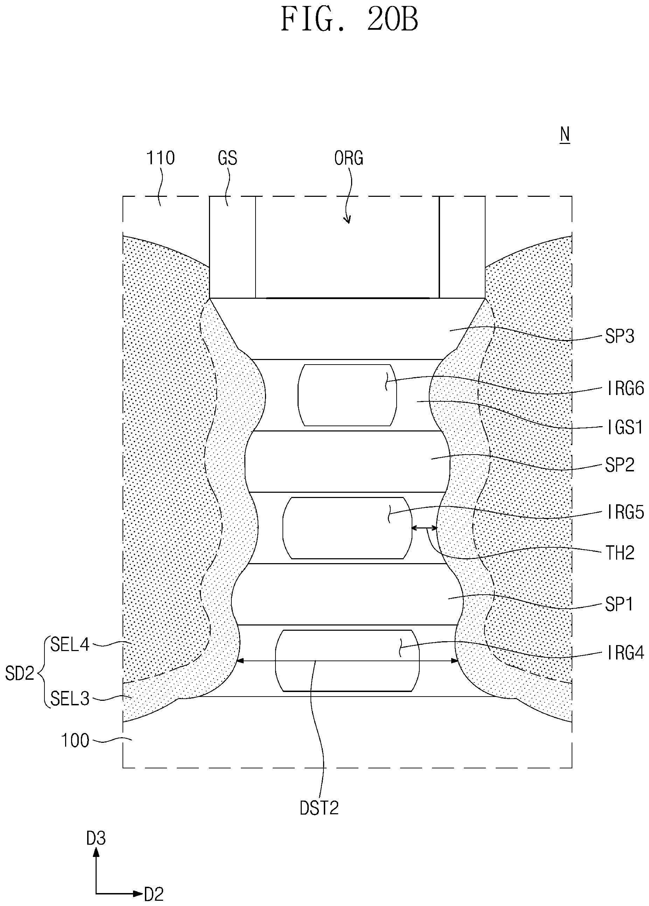

FIGS. 20A and 20B illustrate diagrams showing a method of forming a gate dielectric layer of a semiconductor device according to some example embodiments of the present inventive concepts. In detail, FIG. 20A illustrates an enlarged view showing a method of forming section M depicted in FIG. 8A. FIG. 20B illustrates an enlarged view showing a method of forming section N depicted in FIG. 8B.

Referring to FIGS. 15A, 15B, 20A, and 20B, a first inner gate spacer IGS 1 may be conformally formed in the first, second, and third inner regions IRG1, IRG2, and IRG3, and a second inner gate spacer IGS2 may be conformally formed in the fourth, fifth, and sixth inner regions IRG4, IRG5, and IRG6. The first inner gate spacer IGS 1 and the second inner gate spacer IGS2 may be formed by performing physical vapor deposition (PVD), chemical vapor deposition (CVD), or atomic layer deposition (ALD).

A thickness in the second direction D2 of the first inner gate spacer IGS 1 in the first, second, and third inner regions IRG1, IRG2, and IRG3 may be substantially the same as the first thickness TH1 discussed in FIG. 8A. A thickness in the second direction D2 of the second inner gate spacer IGS2 in the fourth, fifth, and sixth inner regions IRG4, IRG5, and IRG6 may be substantially the same as the second thickness TH2 discussed in FIG. 8B.

The first source/drain patterns SD1 may be spaced apart at a first length DST1 from each other in the second direction D2. The second source/drain patterns SD2 may be spaced apart at a second length DST2 from each other in the second direction D2. The first length DST1 may be greater than the second length DST2. This may be caused by the fact that an etching process is performed such that a width in the second direction D2 of the second recess RS2 defining spaces where the second source/drain patterns SD2 will be formed in a process of FIGS. 11A to 11C is greater than a width in the second direction D2 of the first recess RS 1. As a result, a thickness in the second direction D2 of the first inner gate spacer IGS 1 may be greater than a thickness in the second direction D2 of the second inner gate spacer IGS2.

In a semiconductor device according to some embodiments of the present inventive concepts, a thickness of a first inner gate spacer on, for example, an NMOSFET region may be greater than a thickness of a second inner gate spacer on, for example, a PMOSFET region. As the first inner gate spacer has a larger thickness, a leakage current may be prevented. As the second inner gate spacer has a smaller thickness, a compressive stress provided from a source/drain pattern to a channel pattern may be increased to improve carrier mobility. A semiconductor device may resultantly have improved electrical characteristics and increased reliability.

The aforementioned description provides some embodiments for explaining the present inventive concepts. Therefore, the present inventive concepts are not limited to the embodiments described above, and it will be understood by one of ordinary skill in the art that variations in form and detail may be made therein without departing from the essential features of the present inventive concepts.

## Claims

1. A semiconductor device, comprising:
a substrate that includes a first active pattern and a second active pattern;
a first channel pattern on the first active pattern and a second channel pattern on the second active pattern, each of the first and second channel patterns including a first semiconductor pattern and a second semiconductor pattern that are vertically spaced apart from each other;
a plurality of first source/drain patterns connected to the first channel pattern and spaced apart from each other in a first direction;
a plurality of second source/drain patterns connected to the second channel pattern and spaced apart from each other in the first direction;
a first inner gate electrode between neighboring ones of the first semiconductor patterns;
a second inner gate electrode between neighboring ones of the second semiconductor patterns;
a first inner gate spacer between the first inner gate electrode and a first source/drain pattern of the plurality of first source/drain patterns; and
a second inner gate spacer between the second inner gate electrode and a second source/drain pattern of the plurality of second source/drain patterns,
wherein the first inner gate spacer has a first thickness in the first direction,
wherein the second inner gate spacer has a second thickness in the first direction, and
wherein the first thickness is greater than the second thickness.

2. The semiconductor device of claim 1,
wherein the first thickness ranges from about 2.5 nm to about 3 nm, and
wherein the second thickness ranges from about 1.5 nm to about 2 nm.

3. The semiconductor device of any preceding claim,
wherein the first source/drain patterns include silicon (Si), and
wherein the second source/drain patterns include silicon-germanium (SiGe).

4. The semiconductor device of any preceding claim, further comprising a high-k dielectric layer between the first inner gate electrode and the first inner gate spacer and between the second inner gate electrode and the second inner gate spacer.

5. The semiconductor device of any preceding claim,
wherein, at the same level, a spacing distance between the first inner gate electrode and a neighboring one of the plurality of first source/drains pattern is greater than a spacing distance between the second inner gate electrode and a neighboring one of the plurality of second source/drain patterns.

6. The semiconductor device of any preceding claim, wherein the first inner gate spacer includes:
a first dielectric pattern that surrounds the first inner gate electrode; and
a second dielectric pattern on the first dielectric pattern,
wherein the second dielectric pattern is in contact with the first source/drain pattern, and
wherein the first dielectric pattern and the second dielectric pattern include the same or different dielectric materials.

7. The semiconductor device of claim 6, further comprising:
a high-k dielectric layer between the first inner gate electrode and the first inner gate spacer and between the second inner gate electrode and the second inner gate spacer,
wherein the first dielectric pattern is in contact with the high-k dielectric layer between the first inner gate electrode and the first inner gate spacer, and
wherein the second dielectric pattern is spaced apart from the first inner gate electrode.

8. The semiconductor device of claim 6 or 7, wherein the first dielectric pattern and the second dielectric pattern include silicon oxide.

9. The semiconductor device of claim 6 or 7,
wherein the first dielectric pattern includes silicon nitride, and
wherein the second dielectric pattern includes silicon oxide.

10. The semiconductor device of any of claims 6 to 9,
wherein a thickness in the first direction of the first dielectric pattern is about 50% to about 60% of the first thickness, and
wherein a thickness in the first direction of the second dielectric pattern is about 40% to about 50% of the first thickness.

11. The semiconductor device of any of claims 6 to 10, wherein a sum of thicknesses in the first direction of the first dielectric pattern and the second dielectric pattern is substantially the same as the first thickness.

12. The semiconductor device of any of claims 6 to 11, wherein the first dielectric pattern includes:
a first protective pattern on the first inner gate electrode; and
a second protective pattern on the first protective pattern,
wherein the second protective pattern is between the first protective pattern and the second dielectric pattern, and
wherein the second protective pattern includes a material different from a material of the second dielectric pattern.

13. The semiconductor device of claim 12, wherein the second protective pattern is in contact with the second dielectric pattern.

14. The semiconductor device of any preceding claim,
wherein the second source/drain patterns include silicon-germanium (SiGe),
wherein the second inner gate spacer includes:
a first protective pattern that surrounds the second inner gate electrode; and
a first dielectric pattern on the first protective pattern,
wherein the first dielectric pattern is in contact with the first source/drain pattern,
wherein the first protective pattern includes silicon nitride, and
wherein the first dielectric pattern includes silicon oxide.

15. The semiconductor device of claim 14, wherein the first protective pattern is between the first dielectric pattern and the second inner gate electrode.

## Amended claims

### Amended claims in accordance with Rule 137(2) EPC.

1. A semiconductor device, comprising:
a substrate (100) that includes a first active pattern (AP1) and a second active pattern (AP2), the first active pattern (AP1) provided on a first active region (AR1) and the second active pattern (AP2) provided on a second active region (AR2), the first active region (AR1) being an N-channel Metal-Oxide-Semiconductor Field-Effect Transistor, NMOSFET, region and the second active region (AR2) being a P-channel Metal-Oxide-Semiconductor Field-Effect Transistor, PMOSFET, region;
a first channel pattern (CH1) on the first active pattern (AP1) and a second channel pattern (CH2) on the second active pattern (AP2), each of the first and second channel patterns (CH1, CH2) including a first semiconductor pattern (SP1) and a second semiconductor pattern (SP2) that are vertically spaced apart from each other;
a plurality of first source/drain patterns (SD1) connected to the first channel pattern (CH1) and spaced apart from each other in a first direction (D1);
a plurality of second source/drain patterns (SD2) connected to the second channel pattern (CH2) and spaced apart from each other in the first direction;
a first inner gate electrode between the first active pattern (AP1) and a lowermost one of the plurality of the first semiconductor patterns (SP1) or between neighboring ones of the first semiconductor patterns (SP1);
a second inner gate electrode between the second active pattern (AP2) and a lowermost one of the plurality of second semiconductor patterns (SP2) or between neighboring ones of the second semiconductor patterns (SP2);
a first inner gate spacer (IGS1) between the first inner gate electrode and a first source/drain pattern of the plurality of first source/drain patterns (SD1);
a second inner gate spacer (IGS2) between the second inner gate electrode and a second source/drain pattern of the plurality of second source/drain patterns (SD2); and
a high-k dielectric layer (HK) between the first inner gate electrode and the first inner gate spacer (IGS1) and between the second inner gate electrode and the second inner gate spacer (IGS2),
wherein the first inner gate spacer (IGS1) and the second inner gate spacer (IGS2) are in contact with the high-k dielectric layer (HK),
wherein the first inner gate spacer (IGS1) has a first thickness (TH1) in the first direction, the first thickness (TH1) corresponding to a minimum spacing distance between the first source/drain pattern and the high-k dielectric layer (HK),
wherein the second inner gate spacer (IGS2) has a second thickness (TH2) in the first direction, the second thickness (TH2) corresponding to a minimum spacing distance between the second source/drain pattern and the high-k dielectric layer (HK),
wherein the first thickness (TH1) is greater than the second thickness (TH2), and
wherein an amount of silicon nitride in the first inner gate spacer (IGS1) is greater than an amount of silicon nitride in the second inner gate spacer (IGS2).

2. The semiconductor device of claim 1,
wherein the first thickness (TH1) ranges from about 2.5 nm to about 3 nm, and
wherein the second thickness (TH2) ranges from about 1.5 nm to about 2 nm.

3. The semiconductor device of any preceding claim,
wherein the first source/drain patterns (SD1) include silicon, Si, and
wherein the second source/drain patterns (SD2) include silicon-germanium, SiGe.

4. The semiconductor device of any preceding claim,
wherein, at the same level, a spacing distance between the first inner gate electrode and a neighboring one of the plurality of first source/drains patterns (SD1) is greater than a spacing distance between the second inner gate electrode and a neighboring one of the plurality of second source/drain patterns (SD2).

5. The semiconductor device of any preceding claim, wherein the first inner gate spacer (IGS1) includes:
a first dielectric pattern (PT2) that surrounds the first inner gate electrode; and
a second dielectric pattern (PT1) on the first dielectric pattern (PT2),
wherein the second dielectric pattern (PT1) is in contact with the first source/drain pattern, and
wherein the first dielectric pattern (PT2) and the second dielectric pattern (PT1) include the same or different dielectric materials.

6. The semiconductor device of claim 5,
wherein the first dielectric pattern (PT2) is in contact with the high-k dielectric layer (HK) between the first inner gate electrode and the first inner gate spacer (IGS1), and
wherein the second dielectric pattern (PT1) is spaced apart from the first inner gate electrode.

7. The semiconductor device of claim 5 or 6, wherein the first dielectric pattern (PT2) and the second dielectric pattern (PT1) include silicon oxide.

8. The semiconductor device of claim 5 or 6,
wherein the first dielectric pattern (PT2) includes silicon nitride, and
wherein the second dielectric pattern (PT1) includes silicon oxide.

9. The semiconductor device of any of claims 5 to 8,
wherein a thickness (SNT) in the first direction of the first dielectric pattern (PT2) is about 50% to about 60% of the first thickness (TH1), and
wherein a thickness (PTT) in the first direction of the second dielectric pattern (PT1) is about 40% to about 50% of the first thickness (TH1).

10. The semiconductor device of any of claims 5 to 9, wherein a sum of thicknesses in the first direction of the first dielectric pattern (PT2) and the second dielectric pattern (PT1) is substantially the same as the first thickness (TH1).

11. The semiconductor device of any of claims 5 to 10, wherein the first dielectric pattern (PT2) includes:
a first protective pattern (SN2) on the first inner gate electrode (GE1); and
a second protective pattern (SN1) on the first protective pattern (SN2),
wherein the second protective pattern (SN1) is between the first protective pattern (SN2) and the second dielectric pattern (PT1),
wherein the second protective pattern (SN1) includes a material different from a material of the second dielectric pattern (PT1), and
wherein the second protective pattern (SN1) is in contact with the second dielectric pattern (PT1).

12. The semiconductor device of any preceding claim,
wherein the second source/drain patterns (SD2) include silicon-germanium, SiGe,
wherein the second inner gate spacer (IGS2) includes:
a first protective pattern (SN1) that surrounds the second inner gate electrode (); and
a first dielectric pattern (PT2) on the first protective pattern (SN1),
wherein the first dielectric pattern (PT2) is in contact with the second source/drain pattern,
wherein the first protective pattern (SN1) includes silicon nitride,
wherein the first dielectric pattern (PT2) includes silicon oxide, and
wherein the first protective pattern (SN1) is between the first dielectric pattern (PT2) and the second inner gate electrode.
